# EUROPEAN PATENT SPECIFICATION

(11) **EP 2 690 662 B1**
(45) Date of publication and mention of the grant of the patent: **30.10.2019**
(21) Application number: 13173413.9
(22) Date of filing: 24.06.2013
(51) Int. Cl.: H01L 27/32, H01L 51/52, H01L 51/50

(54) **Organic Light-Emitting Device and Organic Light-Emitting Display Apparatus Including the Same**
Organische lichtemittierende Vorrichtung und organische lichtemittierende Anzeigevorrichtung damit
Dispositif électroluminescent organique et dispositif d'affichage électroluminescent organique comprenant celui-ci

(30) Priority: 24.07.2012 KR 20120080799
(43) Date of publication of application: 29.01.2014
(73) Proprietor: Samsung Display Co., Ltd., Gyeonggi-do (KR)
(72) Inventor: Pyo, Sang-Woo, Gyunggi-Do (KR); Song, Ha-Jin, Gyunggi-Do (KR); Yoo, Byeong-Wook, Gyunggi-Do (KR); Kim, Hyo-Yeon, Gyunggi-Do (KR); Lee, Kwan-Hee, Gyunggi-Do (KR); Shim, Hye-Yeon, Gyunggi-Do (KR); Kwon, Ji-Young, Gyunggi-Do (KR)
(74) Representative: Russell, Tim

(56) References cited:
- EP-A2- 2 372 770
- US-A1- 2008 278 066
- US-A1- 2010 133 994
- US-A1- 2011 180 825
- US-B2- 7 667 388

## Description

The present invention relates to an organic light-emitting device, and an organic light-emitting display apparatus including the organic light-emitting device.

Organic light-emitting devices (OLEDs), which are self-emitting devices, have advantages such as wide viewing angles, excellent contrast, quick response, high luminance and excellent driving voltage characteristics and they can provide multicoloured images. Due to these characteristics, OLEDs have been receiving a growing level of attention.

A typical OLED has a structure comprising a substrate, an anode, a hole transport layer (HTL), an organic emission layer (EML), an electron transport layer (ETL), and a cathode, these being sequentially stacked on the substrate. The HTL, the organic EML, and the ETL are mainly formed of organic compounds. When a voltage is applied between the anode and the cathode, holes injected from the anode move to the EML via the HTL, and electrons injected from the cathode move to the EML via the ETL. The holes and electrons (carriers) recombine in the organic EML to generate excitons. When the excitons drop from an excited state to a ground state, light is emitted.

According to existing techniques of manufacturing a full-colour organic light-emitting device, red, green, and blue organic EMLs can be manufactured using vacuum deposition, spin coating, or laser-induced thermal imaging. Using vacuum deposition techniques, red, green, and blue organic EMLs for each sub-pixel are formed using a shadow mask. Laser-induced thermal imaging involves patterning in each sub-pixel by using a laser, not a shadow mask. Laser-induced thermal imaging is advantageous in that the red, green, and blue organic EMLs may be directly patterned to have different thicknesses without resorting to an additional chemical process.

However, either method may involve using deposition or transfer processes at least three times to form the red, green, and blue organic EMLs for each sub-pixel, and the fine patterning involved can lead to misalignment problems.

An organic light-emitting device with three sub-pixels and a blue emission layer common to all sub-pixels is disclosed in EP 2 372 770 A2.

The present invention provides an organic light-emitting device with improved driving voltage characteristics, the device having one of the red, green, and blue organic emission layers disposed over an entire set of three sub-pixels and not requiring fine patterning. The latter feature provides for less misalignment than would be expected with prior art processes. Each sub-pixel includes a p-type doping auxiliary layer and a resonance auxiliary layer having a thickness corresponding to the resonance distance of the sub-pixel.

The present invention also provides an organic light-emitting display apparatus having improved driving voltage characteristics and improved efficiency of the included organic light-emitting device.

According to a first aspect of the present invention, there is provided an organic light-emitting device according to claim 1 comprising: a substrate; a first sub-pixel, a second sub-pixel, and a third sub-pixel; a first electrode disposed in each of the first, second and third sub-pixels; a second electrode disposed opposite to each of the first electrodes; a first organic emission layer, a second organic emission layer and a third organic emission layer, each disposed between the first electrode of the respective sub-pixel and the second electrode, the third organic emission layer being disposed as a common layer for the first sub-pixel, the second sub-pixel, and the third sub-pixel, the first organic emission layer being disposed in the first sub-pixel on the third organic emission layer, the second organic emission layer being disposed in the second sub-pixel on the third organic emission layer; a first resonance auxiliary layer disposed between the third organic emission layer and the first organic emission layer; a second resonance auxiliary layer disposed between the third organic emission layer and the second organic emission layer; and a first doping auxiliary layer disposed between the third organic emission layer and the first resonance auxiliary layer; and a second doping auxiliary layer disposed between the third organic emission layer and the second resonance auxiliary layer, the first doping auxiliary layer and the second doping auxiliary layer each independently comprising a hole transporting material and a p-type dopant, and wherein the first resonance auxiliary layer and the second resonance auxiliary layer have thicknesses corresponding to resonance distances of the first sub-pixel and the second sub-pixel, respectively.

The p-type dopant may include at least one of 2,3,5,6-tetrafluoro-7,7',8,8'-tetracyanoquinodimethane (F4-TCNQ), 7,7',8,8'-tetracyanoquinodimethane (TCNQ), hexaazatriphenylene hexacarbonitrile (HAT-CN), perylene-3,4,9,10-tetracarboxylic-3,4,9,10-dianhydride (PTCDA), 1,3,2-dioxaborin derivative, MoO₃, WO₃, ReO₃, V₂O₅, SnO₂, MnO₂, CoO₂, TiO₂, ZnO, NiO, Mo(tfd)₃, FeCl₃, FeF₃, SbCl₅, and fullerene (C₆₀).

The p-type dopant may include at least one of the compounds represented by Formulae 1A to 12A, Formulae 1B to 5B and 9B, Formulae 2C, 3C and 5C, Formulae 3D and 5D and Formulae 5E, 5F, 5G, 5H, 5I, 5J, 5K, 5L and 5M:

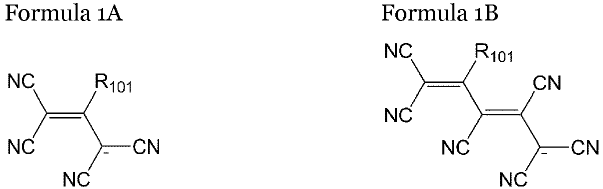

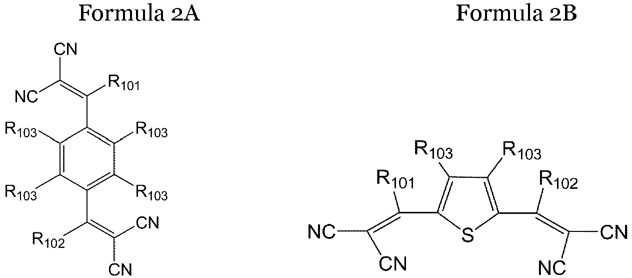

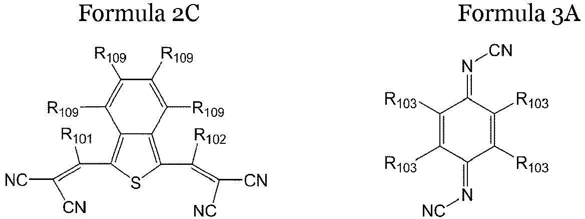

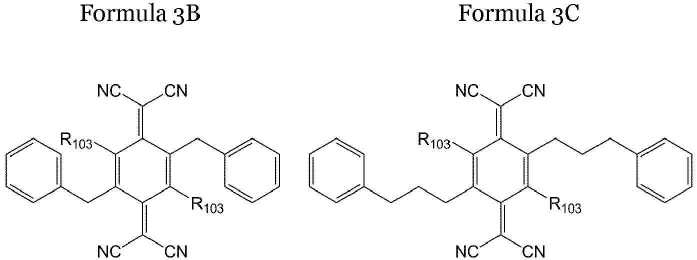

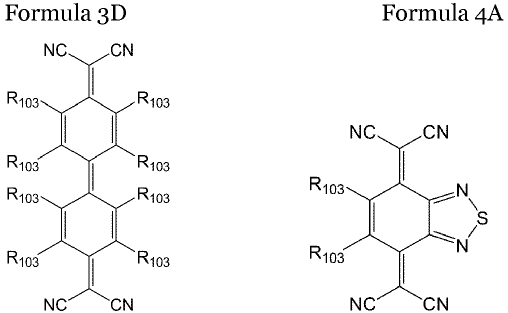

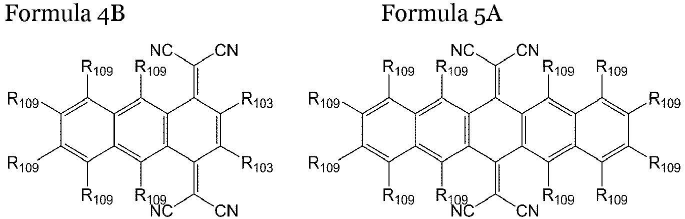

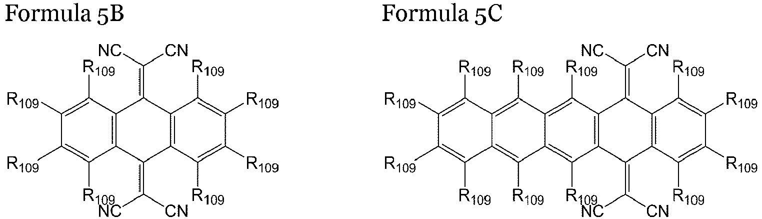

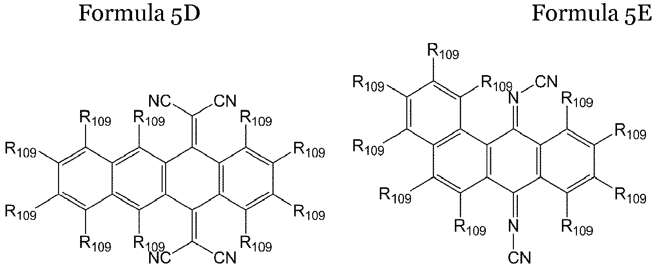

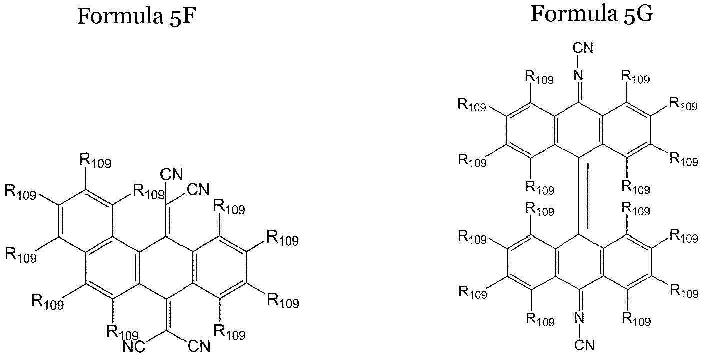

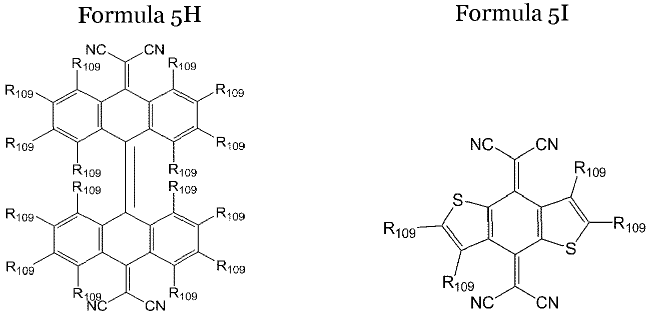

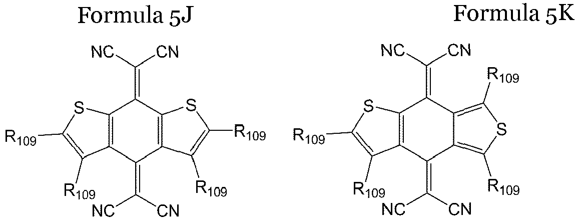

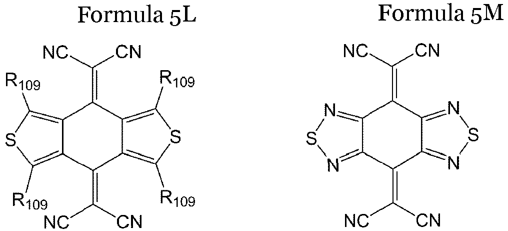

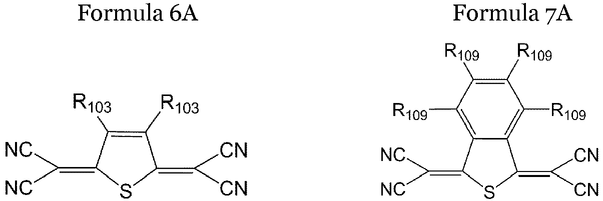

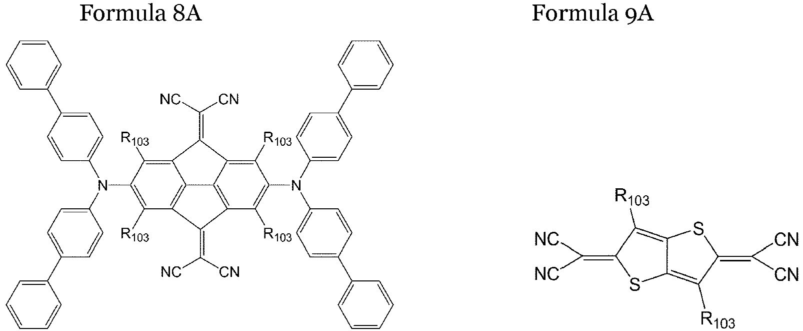

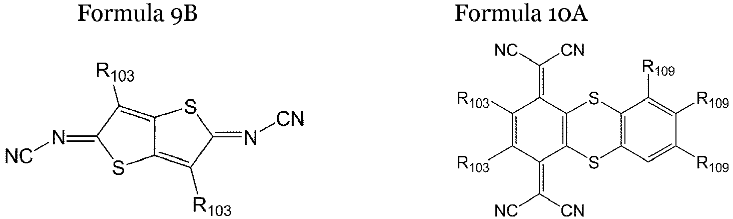

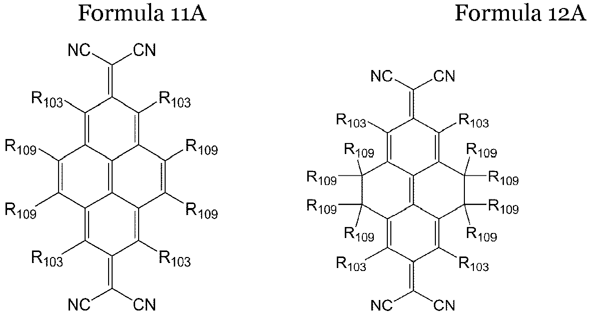

R₁₀₁, R₁₀₂, R₁₀₃, and R₁₀₉ in Formulae 1A to 12A, Formulae 1B to 5B and 9B, Formulae 2C, 3C and 5C, Formulae 3D and 5D and Formulae 5E, 5F, 5G, 5H, 5I, 5J, 5K, 5L and 5M may each independently be selected from a hydrogen atom, a fluorine atom, a cyano group, a substituted or unsubstituted methyl group, a substituted or unsubstituted ethyl group, a substituted or unsubstituted propyl group, a substituted or unsubstituted butyl group, a substituted or unsubstituted ethenyl group, a substituted or unsubstituted methoxy group, a substituted or unsubstituted ethoxy group, and a substituted or unsubstituted propoxy group.

The concentration of the p-type dopant in one of the first doping auxiliary layer and the second doping auxiliary layer may be from about 5wt% to about 10wt%, based on a total weight of the respective doping auxiliary layer.

The first doping auxiliary layer may contact the first resonance auxiliary layer, and the second doping auxiliary layer may contact the second resonance auxiliary layer.

The third organic emission layer may be a blue organic emission layer.

The first resonance auxiliary layer and the second resonance auxiliary layer may have different thicknesses depending on the resonance distances of the first sub-pixel and the second sub-pixel. The resonance distances, in turn, depend on the wavelengths of light emitted from the respective sub-pixels.

The organic light-emitting device may further comprise a first charge generation layer disposed between the third organic emission layer and the first doping auxiliary layer and a second charge generation layer disposed between the third organic emission layer and the second doping auxiliary layer.

The first charge generation layer and the second charge generation layer may each independently include at least one selected from 2,3,5,6-tetrafluoro-7,7',8,8'-tetracyanoquinodimethane (F4-TCNQ), 7,7',8,8'-tetracyanoquinodimethane (TCNQ), hexaazatriphenylene hexacarbonitrile (HAT-CN), perylene-3,4,9,10-tetracarboxylic-3,4,9,10-dianhydride (PTCDA), 1,3,2-dioxaborin derivative, MoO₃, WO₃, ReO₃, V₂O₅, SnO₂, MnO₂, CoO₂, TiO₂, ZnO, NiO, Mo(tfd)₃, FeCl₃, FeF₃, SbCl₅, and fullerene (C₆₀).

The organic light-emitting device may further comprise in each sub-pixel at least one of a hole injection layer and a hole transport layer that are disposed between the corresponding first electrode and the third organic emission layer.

The organic light-emitting device may further include at least one of an electron injection layer and an electron transport layer disposed between the second electrode and the third organic emission layer.

At least one of the electron injection layer and the electron transport layer may comprise at least one of lithium quinolate (LiQ) and Compound 101, which is represented by the following formula:

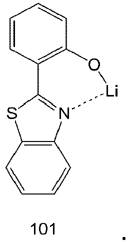

The organic light-emitting device may further include a hole blocking layer disposed between any of the organic emission layers and the electron transport layer.

The organic light-emitting device may be a top-emission type of device.

The organic light-emitting device may further comprise a first lower resonance auxiliary layer disposed between the third organic emission layer and the first doping auxiliary layer; and a second lower resonance auxiliary layer disposed between the third organic emission layer and the second doping auxiliary layer. In such embodiments, the first and second resonance auxiliary layers may alternatively be referred to as the first and second resonance auxiliary layers.

As such, according to an embodiment of the present invention, there is provided an organic light-emitting device comprising: a substrate; a first sub-pixel, a second sub-pixel, and a third sub-pixel; a first electrode disposed in each of the first, second and third sub-pixels; a second electrode disposed opposite to each of the first electrodes; a first organic emission layer, a second organic emission layer and a third organic emission layer, each disposed between the first electrode of the respective sub-pixel and the second electrode, the third organic emission layer being disposed as a common layer for the first sub-pixel, the second sub-pixel, and the third sub-pixel, the first organic emission layer being disposed in the first sub-pixel on the third organic emission layer, the second organic emission layer being disposed in the second sub-pixel on the third organic emission layer; a first resonance auxiliary layer disposed between the third organic emission layer and the first organic emission layer; a second resonance auxiliary layer disposed between the third organic emission layer and the second organic emission layer; a first doping auxiliary layer disposed between the third organic emission layer and the first resonance auxiliary layer; a second doping auxiliary layer disposed between the third organic emission layer and the second resonance auxiliary layer wherein the first resonance auxiliary layer and the second resonance auxiliary layer have thicknesses corresponding to resonance distances of the first sub-pixel and the second sub-pixel, respectively; a first lower resonance auxiliary layer disposed between the third organic emission layer and the first doping auxiliary layer; and a second lower resonance auxiliary layer disposed between the third organic emission layer and the second doping auxiliary layer, the first doping auxiliary layer and the second doping auxiliary layer each independently comprising a hole transporting material and a p-type dopant.

The p-type dopant may include at least one of 2,3,5,6-tetrafluoro-7,7',8,8'-tetracyanoquinodimethane (F4-TCNQ), 7,7',8,8'-tetracyanoquinodimethane (TCNQ), hexaazatriphenylene hexacarbonitrile (HAT-CN), perylene-3,4,9,10-tetracarboxylic-3,4,9,10-dianhydride (PTCDA), 1,3,2-dioxaborin derivative, MoO₃, WO₃, ReO₃, V₂O₅, SnO₂, MnO₂, CoO₂, TiO₂, ZnO, NiO, Mo(tfd)₃, FeCl₃, FeF₃, SbCl₅, fullerene (C₆₀), and Compounds 201A and 201B represented by the following formulae:

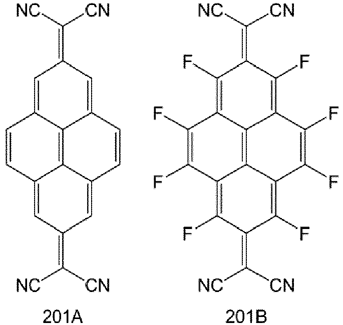

The amount of the p-type dopant in one of the first doping auxiliary layer and the second doping auxiliary layer may be from about 5wt% to about 10wt%, based on the total weight of the respective layer.

The first doping auxiliary layer may contact both the first resonance auxiliary layer and the first lower resonance auxiliary layer, and the second doping auxiliary layer may contact both the second resonance auxiliary layer and the second lower resonance auxiliary layer.

The third organic emission layer may be a blue organic emission layer.

The first resonance auxiliary layer, the first lower resonance auxiliary layer, the second resonance auxiliary layer, and the second lower resonance auxiliary layer may have different thicknesses depending on the resonance distances of the first sub-pixel and the second sub-pixel. The resonance distances, in turn, depend on the wavelength of light emitted from each respective sub-pixel.

The organic light-emitting device may further include a first charge generation layer disposed between the third organic emission layer and the first lower resonance auxiliary layer, and a second charge generation layer disposed between the third organic emission layer and the second lower resonance auxiliary layer.

The first charge generation layer and the second charge generation layer may each independently include at least one selected from 2,3,5,6-tetrafluoro-7,7',8,8'-tetracyanoquinodimethane (F4-TCNQ), 7,7',8,8'-tetracyanoquinodimethane (TCNQ), hexaazatriphenylene hexacarbonitrile (HAT-CN), perylene-3,4,9,10-tetracarboxylic-3,4,9,10-dianhydride (PTCDA), 1,3,2-dioxaborin derivative, MoO₃, WO₃, ReO₃, V₂O₅, SnO₂, MnO₂, CoO₂, TiO₂, ZnO, NiO, Mo(tfd)₃, FeCl₃, FeF₃, SbCl₅, and fullerene (C₆₀).

The organic light-emitting device may further comprise at least one of a hole injection layer and a hole transport layer disposed between at least one first electrode and the corresponding organic emission layer.

The organic light-emitting device may further include at least one of an electron injection layer and an electron transport layer disposed between the second electrode and the third organic emission layer.

For a given sub-pixel, at least one of the electron injection layer and the electron transport layer may include at least one of lithium quinolate (LiQ) and Compound 101, which is represented by the following formula:

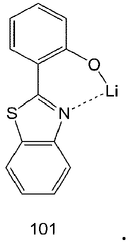

The organic light-emitting device may further include a hole blocking layer disposed between any of the organic emission layers and the electron transport layer.

The organic light-emitting device may be a top-emission type device.

According to a second aspect of the present invention, there is provided an organic light-emitting display apparatus comprising: a transistor including a source, a drain, a gate, and an active layer, and any of the above-described organic light-emitting devices, one of the source and the drain being electrically connected to at least one first electrode of the organic light-emitting device.

A more complete appreciation of the present invention, and many of the attendant advantages thereof, will be readily apparent as the same becomes better understood by reference to the following detailed description when considered in conjunction with the accompanying drawings, wherein:
FIG. 1 is a schematic cross-sectional view of a structure of an organic light-emitting device according to an embodiment of the present invention;
FIG. 2 is a schematic cross-sectional view of a structure of an organic light-emitting device according to another embodiment of the present invention;
FIG. 3 is a schematic cross-sectional view of a structure of an organic light-emitting device according to another embodiment of the present invention;
FIG. 4 is a schematic cross-sectional view of a structure of an organic light-emitting device according to another embodiment of the present invention;
FIG. 5 is a graph of current density versus driving voltage in organic light-emitting devices manufactured according to Examples 1-4 and Comparative Example 1; and
FIG. 6 is a graph showing lifetime characteristics of the organic light-emitting devices manufactured according to Examples 1-4 and Comparative Example 1.

As used herein, the term "and/or" includes any and all combinations of one or more of the associated listed items. Expressions such as "at least one of', when preceding a list of elements, modify the entire list of elements and do not modify the individual elements of the list.

Reference will now be made in detail to the exemplary embodiments of the present invention, examples of which are illustrated in the accompanying drawings.

The elements that are irrelevant to the present invention are not described herein for clarity of the invention. Like reference numerals denote like elements throughout the specification. In the drawings, the thicknesses and sizes of layers or regions are exaggerated for clarity and thus are not drawn to scale.

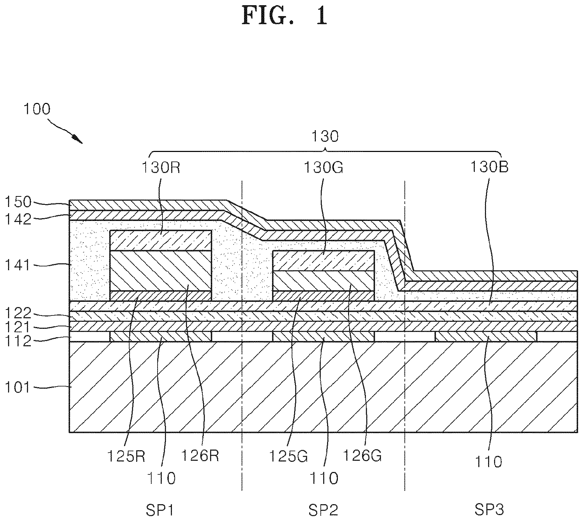

FIG. 1 is a cross-sectional view of the structure of an organic light-emitting device 100 according to an embodiment of the present invention.

Referring to FIG. 1, the organic light-emitting device 100 comprises a substrate 101; a first sub-pixel SP1, a second sub-pixel SP2, and a third sub-pixel SP3; a first electrode 110 disposed in each of the first, second and third sub-pixels; a second electrode 150 disposed opposite to each of the first electrodes 110; organic emission layers (EMLs) 130 disposed between the first electrodes 110 and the second electrode 150 and including a first organic EML 130R, a second organic EML 130G, and a third organic EML 130B; a first resonance auxiliary layer 126R disposed between the third organic EML 130B and the first organic EML 130R; a second resonance auxiliary layer 126G disposed between the third organic EML 130B and the second organic EML 130G; a first doping auxiliary layer 125R disposed between the third organic EML 130B and the first resonance auxiliary layer 126R; and a second doping auxiliary layer 125G disposed between the third organic EML 130B and the second resonance auxiliary layer 126G. The first sub-pixel SP1 may be formed on the substrate 101; the second sub-pixel SP2 may be formed on the substrate 101 and adjacent to the first sub-pixel SPi; the third sub-pixel SP3 may be formed on the substrate 101 and adjacent to the second sub-pixel SP2, the first, second and third sub-pixels each comprising one of the first electrodes 110, which may be disposed on the substrate 101.

Further to the above structure, to facilitate injection and transportation of holes, the organic light-emitting device 100 may further include a hole injection layer 121 and a hole transport layer 122 between the first electrodes 110 and the organic EMLs 130. To facilitate injection and transportation of electrons, the organic light-emitting device 100 may further include an electron injection layer 141 and an electron transport layer 142 between the second electrode 150 and the organic EMLs 130.

The organic light-emitting device 100 may be a full colour organic light-emitting device, with the organic EMLs 130 including the first organic EML 130R, the second organic EML 130G and the third organic EML 130B.

Red, green, and blue organic EMLs of the organic light-emitting device 100 are not patterned within specific sub-pixels, respectively; rather, one of the red, green and blue organic EMLs is formed as a common layer over the entire area comprising all sub-pixels. That is, the third organic EML 130B is not defined to be only within the third sub-pixel SP3 and is disposed as a common layer over the first sub-pixel SP1, the second sub-pixel SP2, and the third sub-pixel SP3. Accordingly, there is no need for fine-patterning the third organic EML 130B to be within the third sub-pixel SP3, and thus the overall patterning process may be simplified, and misalignment is less likely to occur. Furthermore, since a light-emitting material for the third organic EML 130B is coated on the entire surface of the substrate 101, the light-emitting material may deteriorate less, so that the organic light-emitting device 100 may have improved stability relative to existing full-colour organic light-emitting devices. The first organic EML 130R is disposed on the third organic EML 130B in the first sub-pixel SP1, and the second organic EML 130G is disposed on the third organic EML 130B in the second sub-pixel SP2.

The third organic EML 130B may be a blue organic EML. Blue organic EMLs have shorter lifetimes compared to red and green organic EMLs. Accordingly, if a blue organic EML is formed as a common layer for the entire group of three sub-pixels, charge leakage may be minimized, and this is conducive to improving the lifetime of the organic light-emitting device. In the blue organic EML, mobility of holes is greater than that of electrons, and thus generation of excitons may be unbalanced. To reduce this unbalance, the blue organic EML may be disposed as a common layer in a lower region of the organic EML 130. The first organic EML 130R may be a red organic EML, and the second organic EML 130G may be a green organic EML.

The resonance auxiliary layers 126R and 126G for optical thickness adjustment for each colour are disposed in the first sub-pixel SP1 and the second sub-pixel SP2 of the organic light-emitting device 100. The resonance auxiliary layer 126R may be between the first organic EML 130R and the third organic EML 130B, and resonance auxiliary layer 126G may be between the second organic EML 130G and the third organic EML 130B. The third organic EML 130B may be a layer common to all three sub-pixels. The doping auxiliary layer 125R may be between the resonance auxiliary layer 126R and the third organic EML 130B, and the doping auxiliary layer 125G may be between the resonance auxiliary layer 126G and the third organic EML 130B.

The above-described structure will now be described with reference to each pixel. In the first sub-pixel SP1, the third organic EML 130B, the first doping auxiliary layer 125R, the first resonance auxiliary layer 126R, and the first organic EML 130R may be sequentially disposed upon one another. In the second sub-pixel SP2, the third organic EML 130B, the second doping auxiliary layer 125G, the second resonance auxiliary layer 126G, and the second organic EML 130G may be sequentially disposed upon one another. In the third sub-pixel SP3, the third organic EML 130B as the common layer may be disposed without a doping auxiliary layer or a resonance auxiliary layer.

The first resonance auxiliary layer 126R and the second resonance auxiliary layer 126G, as auxiliary layers for optical thickness adjustment, provide a microcavity effect, with different thicknesses depending on resonance distances of the first sub-pixel SP1 and the second sub-pixel SP2. In an embodiment of the invention, the first organic emission layer and the second organic emission layer are substantially of the same thickness.

The microcavity effect may be used to improve light utilization efficiency, i.e., luminance. The microcavity effect may be induced by controlling an optical path length of visible light generated in the organic EMLs 130, i.e., distances between the respective first electrodes 110 and the second electrode 150. This may be achieved by forming the resonance auxiliary layers 126R and 126G in the corresponding sub-pixels, respectively. The distance between the first electrode 110 and the second electrode 150 for maximizing the microcavity effect may vary depending on the colour of light emitted from the sub-pixel of the organic light-emitting device, this optimum distance being relatively large for a red-light emitting device and relatively small for a blue-light emitting device.

Thus, by disposing resonance auxiliary layers 126R and 126G having different thicknesses between the third organic EML 130B and either of the first and second organic EMLs 130R and 130G for different light colours, luminance may be effectively improved. The first resonance auxiliary layer 126R, having a relatively large thickness, may be disposed in the first sub-pixel SP1 emitting red light, and either no resonance auxiliary layer or a resonance auxiliary layer having a relatively small thickness may be disposed in the third sub-pixel SP3, which emits blue light. Comparing the thicknesses of the first and second resonance auxiliary layers, the first resonance auxiliary layer may be of greater thickness than the second resonance auxiliary layer if the wavelength of light emitted from the first sub-pixel is longer than the wavelength of light emitted from the second sub-pixel, and the first resonance auxiliary layer may be of lesser thickness than the second resonance auxiliary layer if the wavelength of light emitted from the first sub-pixel is shorter than the wavelength of light emitted from the second sub-pixel.

The resonance auxiliary layers 126R and 126G may maximize the microcavity effect, and thus improve luminance. However, the resonance auxiliary layers 126R and 126G may increase the total thickness of the organic layers in the corresponding sub-pixels and thus increase the driving voltage of the organic light-emitting device. To suppress these drawbacks and improve driving voltage characteristics, the first and second doping auxiliary layers 125R and 125G may be disposed in the first sub-pixel SP1 and the second sub-pixel SP2, respectively.

The first doping auxiliary layer 125R and the second doping auxiliary layer 125G, which may each independently include a hole transporting material and a p-type dopant, may suppress an increase in driving voltage resulting from the inclusion of the first resonance auxiliary layer 126R and the second resonance auxiliary layer 126G in the respective sub-pixels.

The p-type dopant may be, for example, at least one of 2,3,5,6-tetrafluoro-7,7',8,8'-tetracyanoquinodimethane (F4-TCNQ), 7,7',8,8'-tetracyanoquinodimethane (TCNQ), hexaazatriphenylene hexacarbonitrile (HAT-CN), perylene-3,4,9,10-tetracarboxylic-3,4,9,10-dianhydride (PTCDA), 1,3,2-dioxaborin derivative, MoO₃, WO₃, ReO₃, V₂O₅, SnO₂, MnO₂, CoO₂, TiO₂, ZnO, NiO, Mo(tfd)₃, FeCl₃, FeF₃, SbCl₅, and fullerene (C₆₀).

For example, the p-type dopant may be a cyano group-containing compound. Non-limiting examples of the cyano group-containing compound are compounds represented by Formulae 1A to 12A, Formulae 1B to 5B and 9B, Formulae 2C, 3C and 5C, Formulae 3D and 5D and Formulae 5E, 5F, 5G, 5H, 5I, 5J, 5K, 5L and 5M:

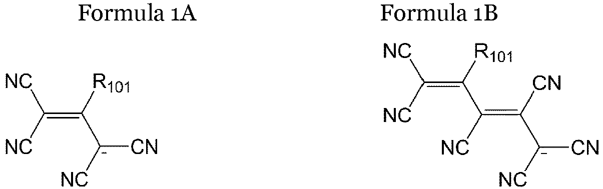

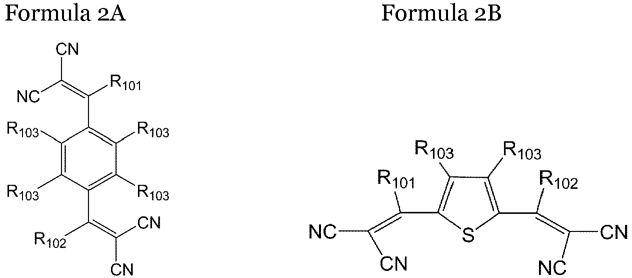

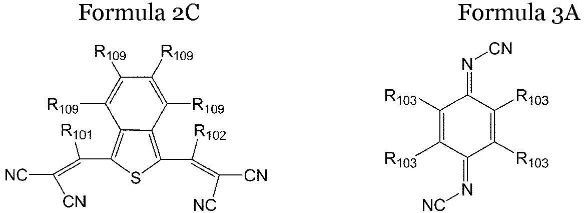

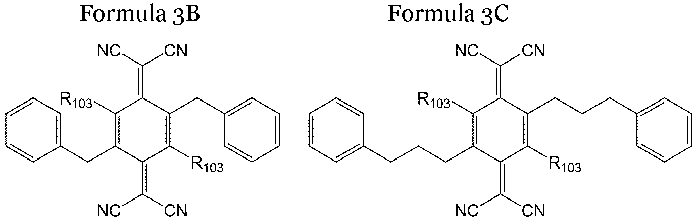

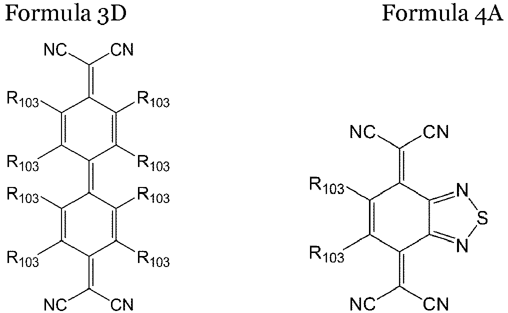

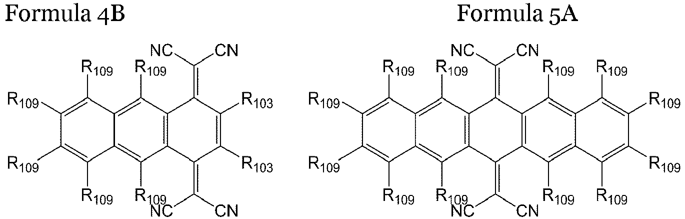

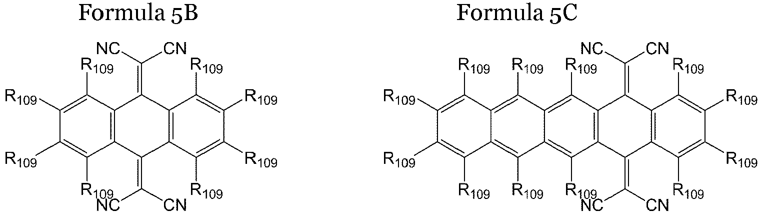

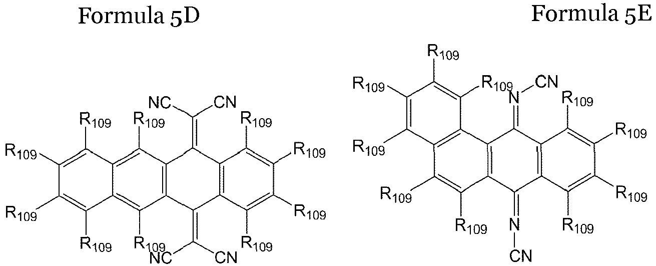

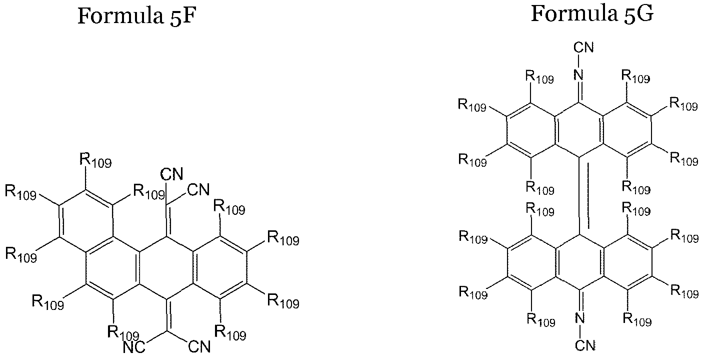

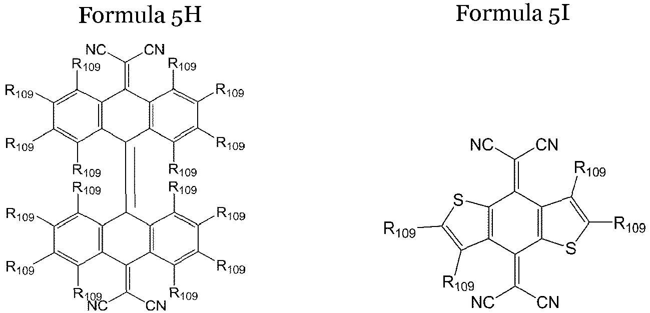

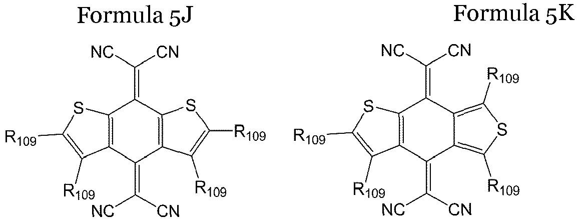

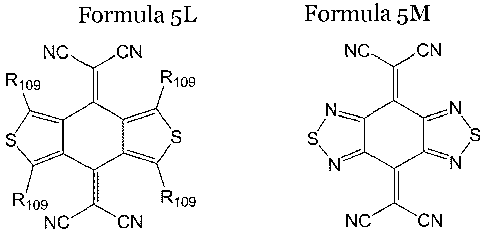

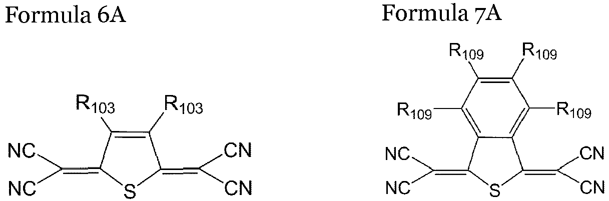

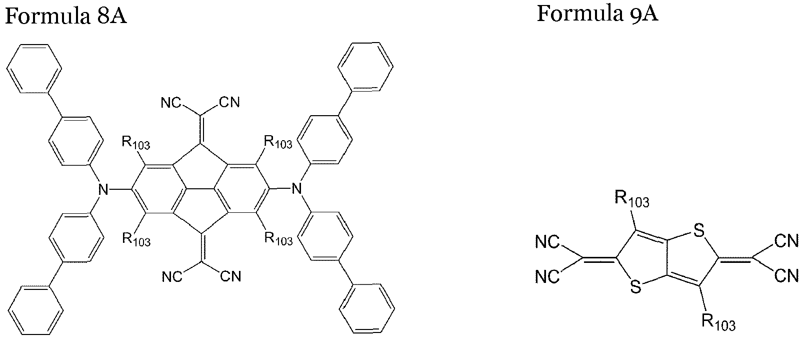

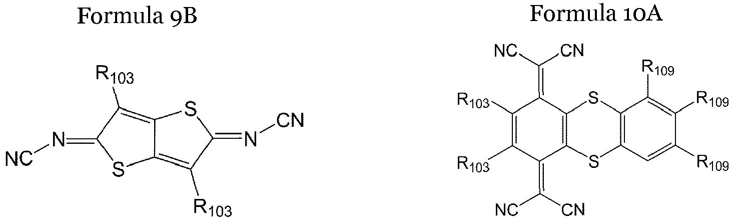

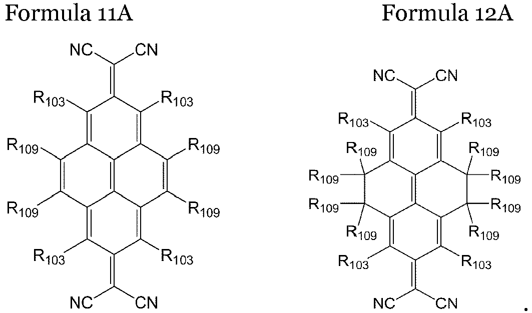

In Formulae 1A to 12A, Formulae 1B to 5B and 9B, Formulae 2C, 3C and 5C, Formulae 3D and 5D and Formulae 5E, 5F, 5G, 5H, 5I, 5J, 5K, 5L and 5M, R₁₀₁, R₁₀₂, R₁₀₃, and R₁₀₉ may each independently be selected from a hydrogen atom, a fluorine atom, a cyano group, a substituted or unsubstituted methyl group, a substituted or unsubstituted ethyl group, a substituted or unsubstituted propyl group, a substituted or unsubstituted butyl group, a substituted or unsubstituted ethenyl group, a substituted or unsubstituted methoxy group, a substituted or unsubstituted ethoxy group, and a substituted or unsubstituted propoxy group.

Due to the first and second doping auxiliary layers 125R and 125G in the organic light-emitting device 100, an increase in driving voltage may be suppressed independently from the thicknesses of the first and second resonance auxiliary layers 126R and 126G. Accordingly, the materials and thicknesses of the first and second resonance auxiliary layers 126R and 126G may be freely chosen.

The concentration of the p-type dopant in either the first doping auxiliary layer 125R or the second doping auxiliary layer 125G may be from about 5 to about 10 wt% based on the total weight of the material of the layer. The p-type dopant may accept electrons from the hole transporting material of the first doping auxiliary layer 125R or the second doping auxiliary layer 125G, and generate holes, thus improving hole transporting ability. When the amount of the p-type dopant is within this range, the first and second doping auxiliary layers 125R and 125G may provide satisfactory hole transporting ability and hole generating ability.

The first doping auxiliary layer 125R may contact the first resonance auxiliary layer 126R, and the second doping auxiliary layer 125G may contact the second resonance auxiliary layer 126G. When the first and second doping auxiliary layers 125R and 125G contact the first and second resonance auxiliary layers 126R and 126G, respectively, the first and second doping auxiliary layers 125R and 125G and the first and second resonance auxiliary layers 126R and 126G may be formed without need to increase the number of chambers (i.e., empty space enclosed by the layers of the device).

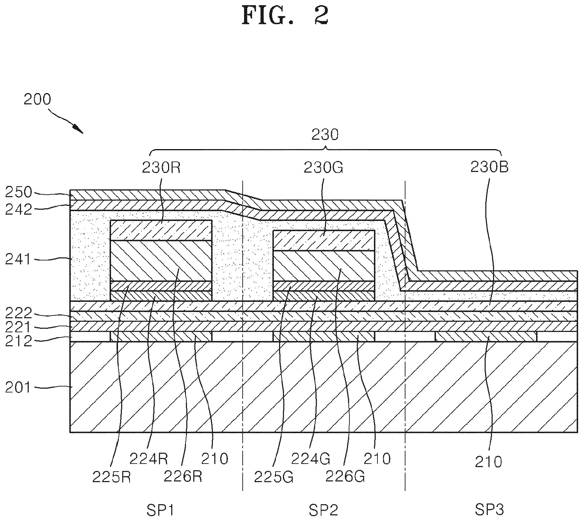

FIG. 2 is a cross-sectional view of a structure of an organic light-emitting device 200 according to another embodiment of the present invention.

Referring to FIG. 2, the organic light-emitting device 200 includes a substrate 201; a first sub-pixel SP1, a second sub-pixel SP2, and a third sub-pixel SP3; a first electrode 210 disposed in each of the first, second and third sub-pixels; a second electrode 250 disposed opposite to each of the first electrodes 210; organic EMLs 230 disposed between the first electrodes 210 and the second electrode 250 and including a first organic EML 230R, a second organic EML 230G, and a third organic EML 230B; a first resonance auxiliary layer 226R disposed between the third organic EML 230B and the first organic EML 230R; a second resonance auxiliary layer 226G disposed between the third organic EML 230B and the second organic EML 230G; a first doping auxiliary layer 225R disposed between the third organic EML 230B and the first resonance auxiliary layer 226R; a second doping auxiliary layer 225G disposed between the third organic EML 230B and the second resonance auxiliary layer 226G; a first charge generation layer 224R disposed between the third organic EML 230B and the first doping auxiliary layer 225R; and a second charge generation layer 224G disposed between the third organic EML 230B and the second doping auxiliary layer 226G.

The first sub-pixel SP1 may be formed on the substrate 201; the second sub-pixel SP2 may be formed on the substrate 201 and adjacent to the first sub-pixel SPi; the third sub-pixel SP3 may be formed on the substrate 201 and adjacent to the second sub-pixel SP2, the first, second and third sub-pixels each comprising a first electrode 210, which may be disposed on the substrate 201.

Further to the above structure, to facilitate injection and transportation of holes, the organic light-emitting device 200 may further include a hole injection layer 221 and a hole transport layer 222 between the first electrodes 210 and the organic EMLs 230R, 230G, 230B. To facilitate injection and transportation of electrons, the organic light-emitting device 200 may further include an electron injection layer 241 and an electron transport layer 242 between the second electrode 250 and the organic EMLs 230R, 230G and 230B.

The EMLs 230R, 230G and 230B, the first and second resonance auxiliary layers 226R and 226G, the first and second doping auxiliary layers 225R and 225G, and the first and second charge generation layers 224R and 224G of the organic light-emitting device 200 will now be described for an embodiment of the invention with reference to each pixel. In the first sub-pixel SP1, the third organic EML 230B, which is a layer common to all three sub-pixels, the first charge generation layer 224R, the first doping auxiliary layer 225R, the first resonance auxiliary layer 226R, and the first organic EML 230R are sequentially disposed upon one another. In the second sub-pixel SP2, the third organic EML 230B, the second charge generation layer 224G, the second doping auxiliary layer 225G, the second resonance auxiliary layer 226G, and the second organic EML 230G are sequentially disposed upon one another. In the third sub-pixel SP3, the third organic EML 230B, the layer common to all three sub-pixels, is disposed without a charge generation layer, a doping auxiliary layer, or a resonance auxiliary layer.

The first and second charge generation layers 224R and 224G may be formed of a single material that may trap electrons and generate holes. The first charge generation layer 224R, disposed between the third organic EML 230B and the first doping auxiliary layer 225R, may increase the density of holes injected and transported from the first electrode 210, thus facilitating migration of the holes towards the first organic EML 230R via the third organic EML 230B. Likewise, the second charge generation layer 224R, disposed between the third organic EML 230B and the second doping auxiliary layer 225G, may increase the density of holes injected and transported from the corresponding first electrode 210, thus facilitating migration of the holes towards the second organic EML 230G via the third organic EML 230B.

The first charge generation layer 224R and the second charge generation layer 224G may each independently include at least one selected from 2,3,5,6-tetrafluoro-7,7',8,8'-tetracyanoquinodimethane (F4-TCNQ), 7,7',8,8'-tetracyanoquinodimethane (TCNQ), hexaazatriphenylene hexacarbonitrile (HAT-CN), perylene-3,4,9,10-tetracarboxylic-3,4,9,10-dianhydride (PTCDA), 1,3,2-dioxaborin derivative, MoO₃, WO₃, ReO₃, V₂O₅, SnO₂, MnO₂, CoO₂, TiO₂, ZnO, NiO, Mo(tfd)₃, FeCl₃, FeF₃, SbCl₅, and fullerene (C₆₀). The first resonance auxiliary layer 226R, as an auxiliary layer for optical thickness adjustment, provides a microcavity effect with a thickness depending on the resonance distance of the first sub-pixel SP1. Likewise, the second resonance auxiliary layer 226G, as an auxiliary layer for optical thickness adjustment, provides a microcavity effect with a thickness depending on the resonance distance of the second sub-pixel SP2.

The first doping auxiliary layer 225R and the second doping auxiliary layer 225G may each independently include a hole transporting material and a p-type dopant. The first doping auxiliary layer 225R may suppress an increase in driving voltage resulting from the inclusion of the first resonance auxiliary layer 226R, and the second doping auxiliary layer 225G may suppress an increase in driving voltage resulting from the inclusion of the second resonance auxiliary layer 226G.

Due to the presence of the first and second doping auxiliary layers 225R and 225G in the organic light-emitting device 200, the increase in driving voltage resulting from inclusion of the first and second resonance auxiliary layers 226R and 226G in the respective sub-pixel laminates can be suppressed regardless of and in a manner independent of the thicknesses of the resonance auxiliary layers. Accordingly, the materials and thicknesses of the first and second resonance auxiliary layers 226R and 226G may be freely chosen without regard to their effects on the driving voltage of the device.

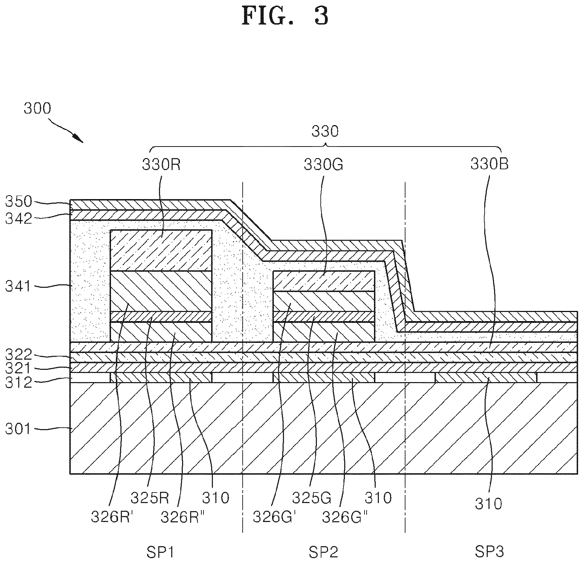

FIG. 3 is a cross-sectional view of a structure of an organic light-emitting device 300 according to another embodiment of the present invention.

Referring to FIG. 3, the organic light-emitting device 300 includes a substrate 301; a first sub-pixel SP1, a second sub-pixel SP2, and a third sub-pixel SP3; a first electrode 310 disposed in each of the first, second and third sub-pixels; a second electrode 350 disposed opposite to each of the first electrodes 310; organic EMLs 330 disposed between the first electrodes 310 and the second electrode 350 and including a first organic EML 330R, a second organic EML 330G, and a third organic EML 330B; a first resonance auxiliary layer 326R' disposed between the third organic EML 330B and the first organic EML 330R; a second resonance auxiliary layer 326G' disposed between the third organic EML 330B and the second organic EML 330G; a first doping auxiliary layer 325R disposed between the third organic EML 330B and the first resonance auxiliary layer 326R'; a second doping auxiliary layer 325G disposed between the third organic EML 330B and the second resonance auxiliary layer 326G'; a first lower resonance auxiliary layer 326R" disposed between the third organic EML 330B and the first doping auxiliary layer 325R; and a second lower resonance auxiliary layer 326G" disposed between the third organic EML 330B and the second doping auxiliary layer 325G.

The first sub-pixel SP1 may be formed on the substrate 301; the second sub-pixel SP2 may be formed on the substrate 301 and adjacent to the first sub-pixel SPi; the third sub-pixel SP3 may be formed on the substrate 301 and adjacent to the second sub-pixel SP2, the first, second and third sub-pixels each comprising the first electrodes 310, which may be disposed on the substrate 301.

Further to the above structure, to facilitate injection and transportation of holes, the organic light-emitting device 300 may further include a hole injection layer 321 and a hole transport layer 322 between the first electrode 310 and the organic EMLs 330R, 330G and 330B. To facilitate injection and transportation of electrons, the organic light-emitting device 300 may further include an electron injection layer 341 and an electron transport layer 342 between the second electrode 350 and the organic EMLs 330R, 330G and 330B.

The organic light-emitting device 300 may be a full colour organic light-emitting device, with the organic EMLs 330 including the first organic EML 330R, the second organic EML 330G, and the third organic EML 330B.

Red, green, and blue organic EMLs of the organic light-emitting device 300 are not patterned within specific sub-pixels, respectively; rather, one of the red, green and blue organic EMLs is formed as a common layer extending throughout all three sub-pixels. That is, the third organic EML 330B may be disposed as a common layer over the first sub-pixel SP1, the second sub-pixel SP2, and the third sub-pixel SP3. Accordingly, there is no need for fine-patterning the third organic EML 330B to be within the third sub-pixel SP3, and thus the overall patterning process may be simplified, and a misalignment is less likely to occur. Furthermore, since a light-emitting material for the third organic EML 330B is coated on the entire surface of the substrate 301, the light-emitting material may deteriorate less, so that the organic light-emitting device 300 may have improved stability relative to existing full-colour organic light-emitting devices. The first organic EML 330R is disposed on the third organic EML 330B in the first sub-pixel SP1, and the second organic EML 330G is disposed on the third organic EML 330B in the second sub-pixel SP2.

The third organic EML 330B may be a blue organic EML. Blue organic EMLs have shorter lifetimes compared to red and green organic EMLs. Accordingly, if the blue organic EML is formed as a common layer for the entire sub-pixels, this may minimize leakage of charges, thus being conducive to improving the lifetime of the organic light-emitting device. In the blue organic EML, mobility of holes is greater than that of electrons, and thus generation of excitons may be unbalanced. To reduce this imbalance, the blue organic EML may be disposed as a common layer across all three sub-pixels. The first organic EML 330R may be a red organic EML, and the second organic EML 330G may be a green organic EML.

The resonance auxiliary layers 326R', 326R", 326G', and 326G", for optical thickness adjustment for each colour, are disposed in the first sub-pixel SP1 and the second sub-pixel SP2 of the organic light-emitting device 300.

The first and second resonance auxiliary layers 326R' and 326G' may be disposed between the third organic EML 330B, which is common to all three sub-pixels, and one of the corresponding first and second organic EML 330R and 330G in the corresponding sub-pixels. The first and second lower resonance auxiliary layers 326R" and 326G" may be disposed between the third organic EML 330B and one of the corresponding first and second doping auxiliary layers 325R and 325G, which will be described later. The first and second doping auxiliary layers 325R and 325G may be disposed between the first upper and lower resonance layers 326R' and 326R", and between the second upper and lower resonance layers 326G' and 325G", respectively.

The above-described structure will now be described with reference to each pixel. In the first sub-pixel SP1, the third organic EML 330B, the first lower resonance auxiliary layer 326R", the first doping auxiliary layer 325R, the first resonance auxiliary layer 326R', and the first organic EML 330R are sequentially disposed upon one another. In the second sub-pixel SP2, the third organic EML 330B, the second lower resonance auxiliary layer 326G", the second doping auxiliary layer 325G, the second resonance auxiliary layer 326G', and the second organic EML 330G are sequentially disposed upon one another. In the third sub-pixel SP3, the third organic EML 330B as the common layer is disposed without resonance auxiliary layers or doping auxiliary layers. The first resonance auxiliary layer 326R' and the first lower resonance auxiliary layer 326R", as auxiliary layers for optical thickness adjustment in the first sub-pixel SP1, provide a microcavity effect with thicknesses depending on the resonance distances of the first sub-pixel SP1. Likewise, the second resonance auxiliary layer 326G' and the second lower resonance auxiliary layer 326G", as auxiliary layers for optical thickness adjustment in the second sub-pixel SP2, provide a microcavity effect with thicknesses depending on the resonance distances of the first sub-pixel SP1.

The microcavity effect may be induced by controlling an optical path length of visible light generated in the organic EMLs 330R, 330G and 330B, i.e., a distance between each of the first electrodes 310 and the second electrode 350. This may be achieved by forming the resonance auxiliary layers 326R', 326R", 326G', and 326G" in the corresponding sub-pixels. The distance between each of the first electrodes 310 and the second electrode 350, for maximizing the microcavity effect, may vary depending on the colour of light emitted from the organic light-emitting device and may be relatively large for a red light emitting device and relatively small for a blue light emitting device.

Thus, by disposing resonance auxiliary layers 326R', 326R", 326G', 326G" having different thicknesses between the third organic EML 330B and either of the first and second organic EMLs 330R and 330G in the corresponding sub-pixels for different light colours, luminance may be effectively improved. The first upper and lower resonance auxiliary layers 326R' and 326R", having relatively large thicknesses, may be disposed in the first sub-pixel SP1 emitting red light, and no resonance auxiliary layer or a resonance auxiliary layer having a relatively small thickness may be disposed in the third sub-pixel SP3 emitting blue light.

The resonance auxiliary layers 326R', 326R", 326G', and 326G" may maximize the microcavity effect and thus improve luminance. However, the resonance auxiliary layers 326R', 326R", 326G', and 326G" may increase the total thickness of the organic layers in the corresponding sub-pixels, thus increasing the driving voltage of the organic light-emitting device. To suppress this drawback and improve driving voltage characteristics, the first and second doping auxiliary layers 325R and 325G may be disposed in the first sub-pixel SP1 and the second sub-pixel SP2, respectively.

The first doping auxiliary layer 325R and the second doping auxiliary layer 325G, which may each independently include a hole transporting material and a p-type dopant, may suppress the increase in driving voltage resulting from the inclusion of the first and second resonance auxiliary layers 326R', 326R", 326G' and 326G".

The p-type dopant may be, for example, at least one of 2,3,5,6-tetrafluoro-7,7',8,8'-tetracyanoquinodimethane (F4-TCNQ), 7,7',8,8'-tetracyanoquinodimethane (TCNQ), hexaazatriphenylene hexacarbonitrile (HAT-CN), perylene-3,4,9,10-tetracarboxylic-3,4,9,10-dianhydride (PTCDA), a 1,3,2-dioxaborin derivative, MoO₃, WO₃, ReO₃, V₂O₅, SnO₂, MnO₂, CoO₂, TiO₂, ZnO, NiO, Mo(tfd)₃, FeCl₃, FeF₃, SbCl₅, and fullerene (C₆₀).

For example, the p-type dopant may be a cyano group-containing compound 201A or 201B, represented by the following formulae:

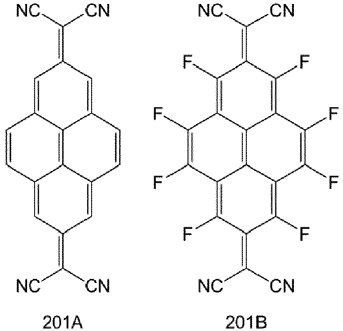

By adjusting the first doping auxiliary layer 325R, which is disposed between the first lower resonance auxiliary layer 326R" and the first resonance auxiliary layer 326R', the increase in driving voltage resulting from inclusion of the resonance auxiliary layers may be suppressed. Accordingly, the materials and thicknesses of the first lower and resonance auxiliary layers 326R" and 326R' may be freely chosen without regard for their effects on the driving voltage of the device.

Likewise, by adjusting the second doping auxiliary layer 325G, which is disposed between the second lower resonance auxiliary layer 326G" and the second resonance auxiliary layer 326G', the increase in driving voltage resulting from inclusion of the resonance auxiliary layers may be suppressed. Accordingly, the materials and thicknesses of the second lower and resonance auxiliary layers 326G" and 326G' may be freely chosen without regard for their effects on the driving voltage of the device. The amount of the p-type dopant in the first doping auxiliary layer 325R or the second doping auxiliary layer 325G may be from about 5 to about 10 wt% based on the total weight of the respective layer material. The p-type dopant may accept electrons from the hole transporting material of the first doping auxiliary layer 325R or the second doping auxiliary layer 325G and generate holes, thus improving hole transporting ability within the laminate. When the amount of the p-type dopant is within this range, the first and second doping auxiliary layers 325R and 325G may provide satisfactory hole transporting ability and hole generating ability.

The first doping auxiliary layer 325R may contact both the first resonance auxiliary layer 326R' and the first lower resonance auxiliary layer 326R" at the same time, and the second doping auxiliary layer 325G may contact both the second resonance auxiliary layer 326G' and the second lower resonance auxiliary layer 326G" at the same time. When the first and second doping auxiliary layers 325R and 325G contact the first and second resonance auxiliary layers 326R', 326R", 326G', and 326G", the first and second doping auxiliary layers 325R and 325G, and the first and second resonance auxiliary layers 326R', 326R", 326G', and 326G" may be formed without need to increase the number of chambers formed within the device.

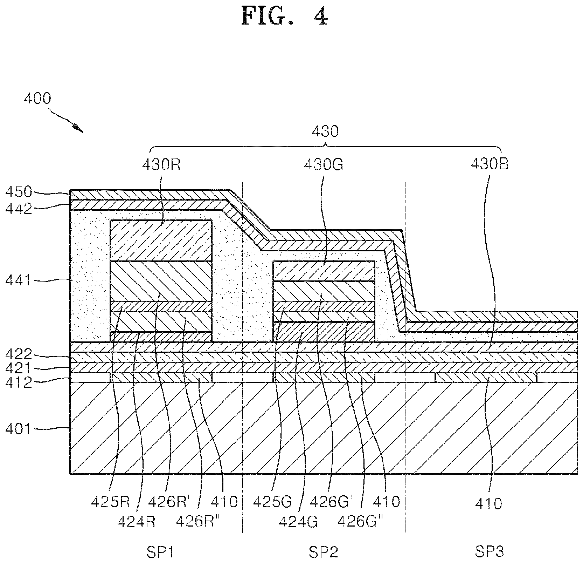

FIG. 4 is a cross-sectional view of a structure of an organic light-emitting device 400 according to another embodiment of the present invention.

Referring to FIG. 4, the organic light-emitting device 400 includes a substrate 401; a first sub-pixel SP1, a second sub-pixel SP2, and a third sub-pixel SP3; a first electrode 410 disposed in each of the first, second and third sub-pixels; a second electrode 450 disposed opposite to each of the first electrodes 410; organic EMLs 430 disposed between the first electrodes 410 and the second electrode 450 and including a first organic EML 430R, a second organic EML 430G, and a third organic EML 430B; a first resonance auxiliary layer 426R' disposed between the third organic EML 430B and the first organic EML 430R; a second resonance auxiliary layer 426G' disposed between the third organic EML 430B and the second organic EML 430G; a first doping auxiliary layer 425R disposed between the third organic EML 430B and the first resonance auxiliary layer 426R'; a second doping auxiliary layer 425G disposed between the third organic EML 430B and the second resonance auxiliary layer 426G'; a first lower resonance auxiliary layer 426R" disposed between the third organic EML 430B and the first doping auxiliary layer 425R; a second lower resonance auxiliary layer 426G" disposed between the third organic EML 430B and the second doping auxiliary layer 425G; a first charge generation layer 424R disposed between the third organic EML 430B and the first lower resonance auxiliary layer 426R"; and a second charge generation layer 424G disposed between the third organic EML 430B and the second lower resonance auxiliary layer 426G".

The first sub-pixel SP1 may be formed on the substrate 401; the second sub-pixel SP2 may be formed on the substrate 401 and adjacent to the first sub-pixel SPi; the third sub-pixel SP3 may be formed on the substrate 401 and adjacent to the second sub-pixel SP2, the first, second and third sub-pixels each comprising a first electrode 410, which may be disposed on the substrate 401.

Further to the above structure, to facilitate injection and transportation of holes, the organic light-emitting device 400 may further include a hole injection layer 421 and a hole transport layer 422 between the first electrode 410 and the organic EMLs 430R, 430G and 430B. To facilitate injection and transportation of electrons, the organic light-emitting device 400 may further include an electron injection layer 441 and an electron transport layer 442 between the second electrode 450 and the organic EMLs 430R, 430G and 430B.

The EMLs 430R, 430G and 430B, the first and second resonance auxiliary layers 426R', 426R", 426G' and 426G", the first and second doping auxiliary layers 425R and 425G, and the first and second charge generation layers 424R and 424G of the organic light-emitting device 400 will now be described with reference to each pixel. In the first sub-pixel SP1, the third organic EML 430B, which is a layer common to all three sub-pixels, the first charge generation layer 424R, the first lower resonance auxiliary layer 426R", the first doping auxiliary layer 425R, the first resonance auxiliary layer 426R', and the first organic EML 430R are sequentially disposed upon one another. In the second sub-pixel SP2, the third organic EML 430B, the second charge generation layer 424G, the second lower resonance auxiliary layer 426G", the second doping auxiliary layer 425G, the second resonance auxiliary layer 426G', and the second organic EML 430G are sequentially disposed upon one another. In the third sub-pixel SP3, the third organic EML 430B as the common layer is disposed without charge generation layers, doping auxiliary layers, or resonance auxiliary layers.

The first and second charge generation layers 424R and 424G may be formed of a single material with capability for trapping electrons and generating holes. The first charge generation layer 424R, disposed between the third organic EML 430B and the first lower resonance auxiliary layer 426R", may increase the density of holes injected and transported from the first electrode 410, thus facilitating migration of the holes towards the first organic EML 430R via the third organic EML 430B. Likewise, the second charge generation layer 424R, disposed between the third organic EML 430B and the second lower resonance auxiliary layer 426G", may increase the density of holes injected and transported from the first electrode 410, thus facilitating migration of the holes towards the second organic EML 430G via the third organic EML 430B.

The first charge generation layer 424R and the second charge generation layer 424G may each independently include at least one selected from 2,3,5,6-tetrafluoro-7,7',8,8'-tetracyanoquinodimethane (F4-TCNQ), 7,7',8,8'-tetracyanoquinodimethane (TCNQ), hexaazatriphenylene hexacarbonitrile (HAT-CN), perylene-3,4,9,10-tetracarboxylic-3,4,9,10-dianhydride (PTCDA), 1,3,2-dioxaborin derivative, MoO₃, WO₃, ReO₃, V₂O₅, SnO₂, MnO₂, CoO₂, TiO₂, ZnO, NiO, Mo(tfd)₃, FeCl₃, FeF₃, SbCl₅, and fullerene (C₆₀).

The first resonance auxiliary layer 426R' and the first lower resonance auxiliary layer 426R", as auxiliary layers for optical thickness adjustment in the first sub-pixel SP1, provide a microcavity effect with thicknesses depending on the resonance distance of the first sub-pixel SP1. Likewise, the second resonance auxiliary layer 426G' and the second lower resonance auxiliary layer 426G", as auxiliary layers for optical thickness adjustment in the second sub-pixel SP2, provide a microcavity effect with thicknesses depending on the resonance distance of the second sub-pixel SP2.

The first doping auxiliary layer 425R and the second doping auxiliary layer 425G may each independently include a hole transporting material and a p-type dopant. The first doping auxiliary layer 425R may suppress an increase in driving voltage resulting from the inclusion of the first resonance auxiliary layer 426R' and the first lower resonance auxiliary layer 426R" in the sub-pixel laminate, and the second doping auxiliary layer 425G may suppress an increase in driving voltage resulting from the inclusion of the second resonance auxiliary layer 426G' and the second lower resonance auxiliary layer 426G" in the sub-pixel laminate.

Due to the presence of the first and second doping auxiliary layers 425R and 425G in the organic light-emitting device 400, the increase in driving voltage caused by inclusion of the resonance auxiliary layers may be suppressed without regard to the thicknesses of the first and second resonance auxiliary layers 426R', 426R", 426G', and 426G". Accordingly, the materials and thicknesses of the first and second resonance auxiliary layers 426R', 426R", 426G', and 426G" may be freely chosen without regard to their effects on the driving voltage of the device.

Hereinafter, a structure of the organic light-emitting device 100, and a method of manufacturing the same, according to an embodiment of the present invention, will be described with reference to FIG. 1.

First, the substrate 101 may be formed of a transparent glass material including SiO₂ as a main component. In an embodiment, the substrate 101 is formed of a transparent plastic material, but is not limited thereto. Examples of the plastic material are insulating organic materials including polyethersulphone (PES), polyacrylate (PAR), polyetherimide (PEI), polyethylene naphthalate (PEN), polyethyleneterephthalate (PET), polyphenylene sulfide (PPS), polyallylate, polyimide, polycarbonate (PC), cellulose triacetate (TAC), and cellulose acetate propionate (CAP).

The substrate 101 may be formed of a metal substrate. For example, the substrate 101 may comprise carbon, iron, chromium, manganese, nickel, titanium, molybdenum, stainless steel (SUS), Invar alloy, Inconel alloy, Kovar alloy, or a combination thereof, but is not limited thereto. For example, the substrate 101 may be formed of metal foil.

After planarizing an upper surface of the substrate 101, an insulating layer 112 may be formed on the upper surface of the substrate 101 in order to prevent permeation of impurities thereinto. The insulating layer 112 may be formed of SiO₂ and/or SiNx, but is not limited thereto.

The first electrodes 110 may be disposed on the substrate 101. The first electrode 110 may be formed from a first electrode-forming material by deposition, sputtering, or the like. When the first electrode 110 constitutes an anode, a material having a high work function that may facilitate hole injection may be used as the first electrode-forming material. The first electrode 110 may be a reflective electrode or a transmission electrode. A transparent material with high conductivity, such as ITO, IZO, SnO₂, and ZnO, may be used as the first electrode-forming material. In an embodiment, the first electrodes 110 are formed as reflective electrodes using one of magnesium (Mg), aluminum (Al), aluminum-lithium (Al-Li), calcium (Ca), magnesium-indium (Mg-In), magnesium-silver (Mg-Ag), and the like. The first electrodes 110 may have a single-layer structure or a multi-layer structure including at least two layers. For example, the first electrodes 110 may have a three-layered structure of ITO/Ag/ITO, but are not limited thereto.

The organic light-emitting device 100 may be a top-emission type device. In this regard, the first electrodes 110 may be formed as reflective electrodes or may be formed as transmission electrodes with reflective plates under the transmission electrodes.

For example, the first electrodes 110 and the second electrode 120 may function as anodes and a cathode, respectively. However, the reverse is also possible.

The HIL 121 may be disposed on the first electrode 110. The HIL 121 may be formed on the first electrode 110 using any of a variety of methods, such as vacuum deposition, spin coating, casting, Langmuir-Blodgett (LB) deposition, or the like. When the HIL 121 is formed using vacuum deposition, the deposition conditions may vary according to the material that is used to form the HIL 121 and the structure and thermal properties of the HIL 121 to be formed. For example, the vacuum depositions may be performed at a temperature of about 100 to about 500°C, a pressure of about 0.133 x 10⁻⁶ Pa (10⁻⁸ torr) to about 0.133 Pa (10⁻³ torr), and a deposition rate of about 0.001 to about 10 nm/sec (0.01 to about 100 Å/sec). When the HIL 121 is formed using spin coating, the coating conditions may vary according to a compound that is used to form the HIL 121 and the structure and thermal properties of the HIL 121 to be formed. For example, the spin coating may be performed at a coating rate of about 2000 to about 5000 rpm and a temperature for heat treatment which is performed to remove a solvent after the coating may be from about 80 to about 200°C.

Non-limiting examples of HIL forming materials are N,N'-diphenyl-N,N'-bis-[4-(phenyl-m-tolyl-amino)-phenyl]-biphenyl-4,4'-diamine, (DNTPD), a phthalocyanine compound such as copperphthalocyanine, 4,4',4"-tris (3-methylphenylphenylamino) triphenylamine (m-MTDATA), N,N'-di(1-naphthyl)-N,N'-diphenylbenzidine (NPB), TDATA, 2T-NATA, polyaniline/dodecylbenzenesulfonic acid (Pani/DBSA), poly(3,4-ethylenedioxythiophene)/poly(4-styrenesulfonate) (PEDOT/PSS), polyaniline/camphor sulfonic acid (Pani/CSA), and polyaniline)/poly(4-styrenesulfonate (PANI/PSS). The thickness of the HIL 121 may be from about 10 nm (100 Å) to about 1000 nm (10000 Å), and, in some embodiments, may be from about 10 nm (100 Å) to about 100 nm (1,000 Å). When the thickness of the HIL 121 is within these ranges, the HIL 121 may have satisfactory hole injecting ability without resulting in a substantial increase in the driving voltage.

The HTL 122 may be formed on the HIL 121. When the HTL 122 is formed using vacuum deposition or spin coating, the conditions for deposition and coating may be similar to those for the formation of the HIL 121, although the conditions for the deposition and coating may vary according to the material that is used to form the HTL 122.

Non-limiting examples of suitable known HTL forming materials are carbazole derivatives, such as N-phenylcarbazole or polyvinylcarbazole, N,N'-bis(3-methylphenyl)-N,N'-diphenyl-[1,1-biphenyl]-4,4'-diamine (TPD), 4,4',4"-tris(N-carbazolyl)triphenylamine (TCTA), and N,N'-di(1-naphthyl)-N,N'-diphenylbenzidine) (NPB). The thickness of the HTL 122 may be from about 5 nm (50 Å) to about 200 nm (2,000 Å), and in some embodiments, is from about 10 nm (100 Å) to about 150 nm (1,500 Å). When the thickness of the HTL 385 is within these ranges, the HTL 385 may have satisfactory hole transporting ability without a substantial increase in driving voltage.

If one of the HIL 121 and the HTL 122 is disposed on one of the first electrodes 110, the other one cannot be excluded. In some embodiments, one of the HIL 121 and the HTL 122 may be formed to include multiple layers representing both hole injection and hole transport capability. In an embodiment, instead of forming distinct HIL and HTL layers, a functional layer (not shown) having both hole injection and hole transport capabilities is formed. The functional layer having both hole injection and hole transport capabilities may be formed using at least one material from each group of the hole injection layer materials and hole transport layer materials. The thickness of the functional layer may be from about 50 nm (500 Å) to about 1,000 nm (10,000 Å), and, in some embodiments, may be from about 10 nm (100 Å) to about 100 nm (1,000 Å). When the thickness of the functional layer having both hole injection and hole transport capabilities is within these ranges, the functional layer may have satisfactory hole injection and transport capabilities without causing a substantial increase in driving voltage.

In an embodiment, the organic EML 130 is disposed on the HTL 122 or on the functional layer (not shown) having both hole injection and hole transport capabilities. When the organic EML 130 is formed using vacuum deposition or spin coating, the deposition and coating conditions may be similar to those for the formation of the HIL, though the conditions for deposition and coating may vary according to the material that is used to form the EML 130.

Non-limiting examples of materials useful as hosts for the organic EMLs 130 are Alq₃, (DPVBi) 4,4'-bis-(2,2-diphenyl-ethen-1-yl)biphenyl, (Gaq3) tris(8-hydroxyquinolinolato)gallium, (CBP) 4,4'-N,N'-dicarbazole-biphenyl, (PVK) poly(N-vinylcarbazole), (ADN) 9,10-di(naphthalene-2-yl)anthracene, 4,4',4"-tris(N-carbazolyl)triphenylamine (TCTA), (TPBI) 1,3,5-tris(N-phenylbenzimidazole-2-yl)benzene, (TBADN) 3-tert-butyl-9,10-di(naphth-2-yl)anthracene, E3, (DSA) distyrylarylene, and (dmCBP) 4,4'-biscarbazolyl-2,2'-dimethylbiphenyl.

The organic EMLs 130 may include the first organic EML 130R, the second organic EML 130G, and the third organic EML 130B, which may, for example, correspond to a red EML, a green EML, and a blue EML, respectively. At least one of the red EML, the green EML, and the blue EML may include a dopant below (ppy = phenylpyridine).

Non-limiting examples of dopants useful for a blue EML include compounds represented by the following formulae.

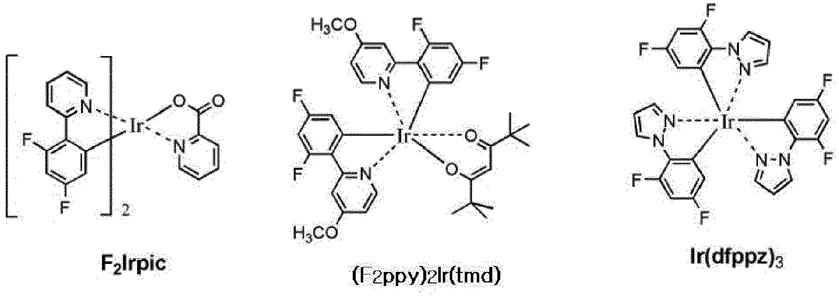

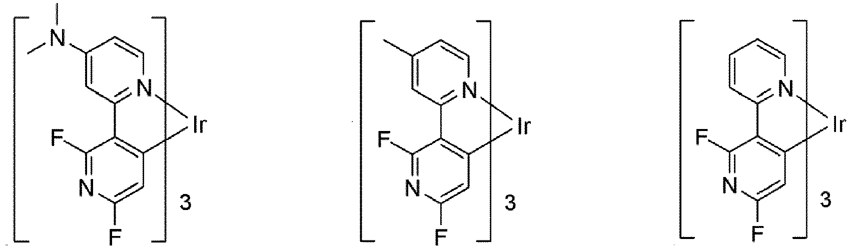

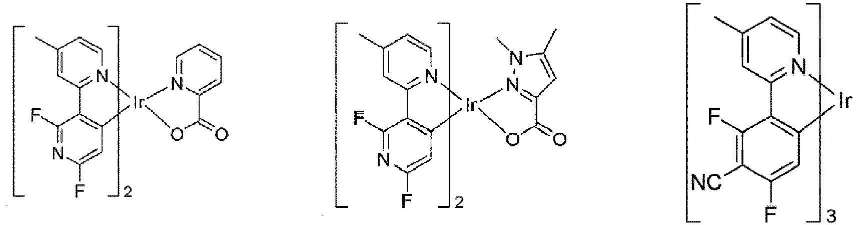

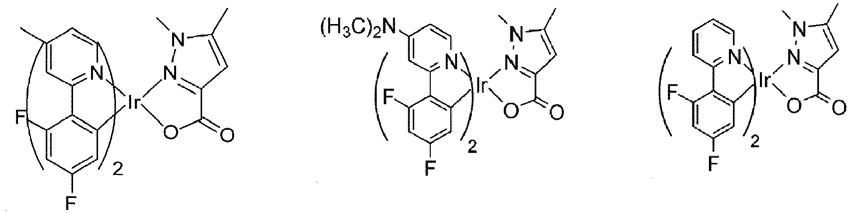

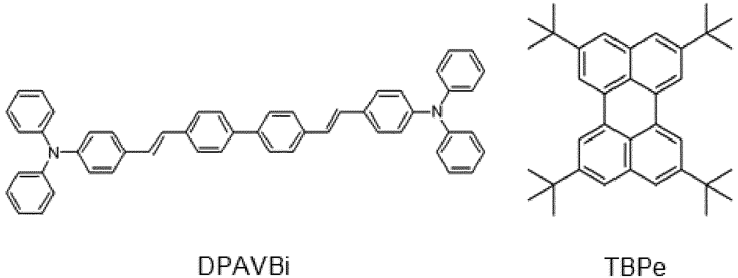

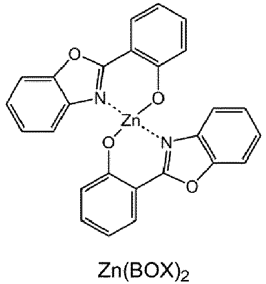

Non-limiting examples of dopants useful for a red EML include compounds represented by the following formulae.

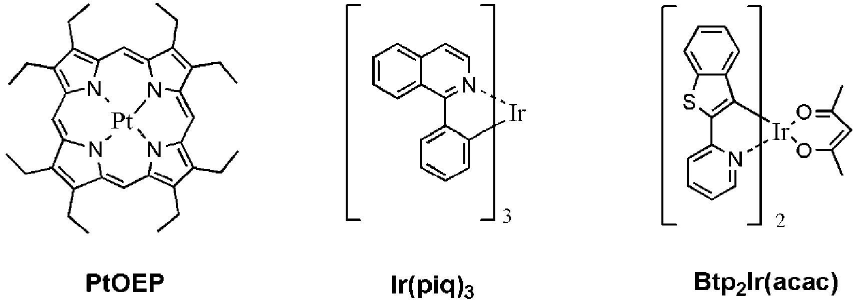

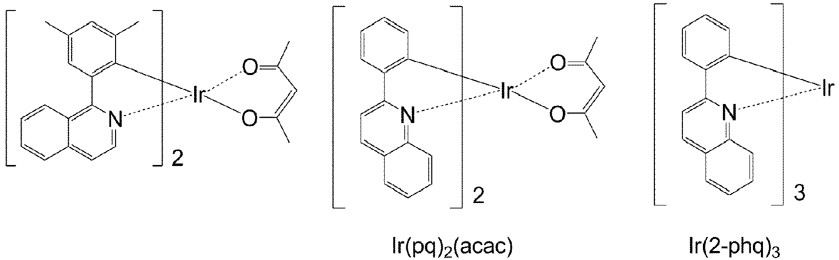

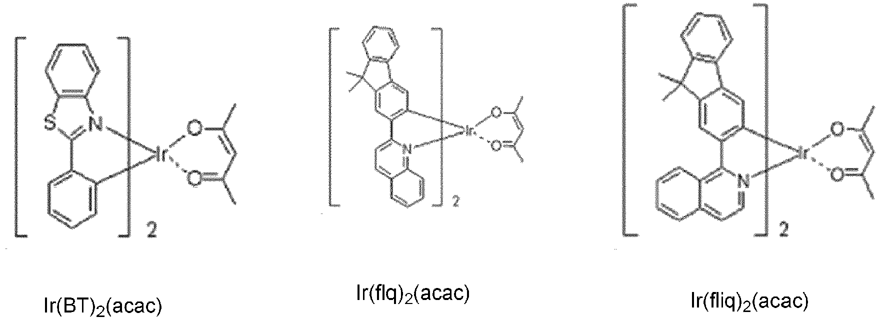

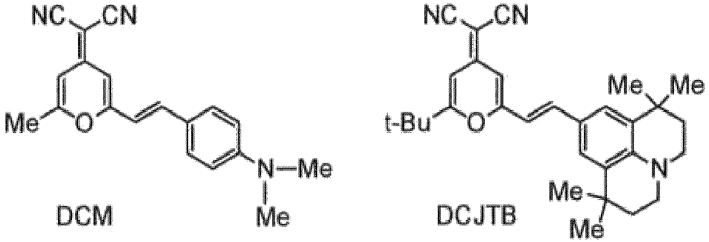

Non-limiting examples of dopants useful for a green EML include compounds represented by the following formulae.

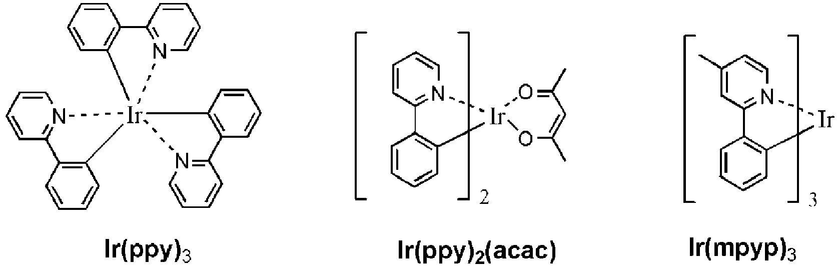

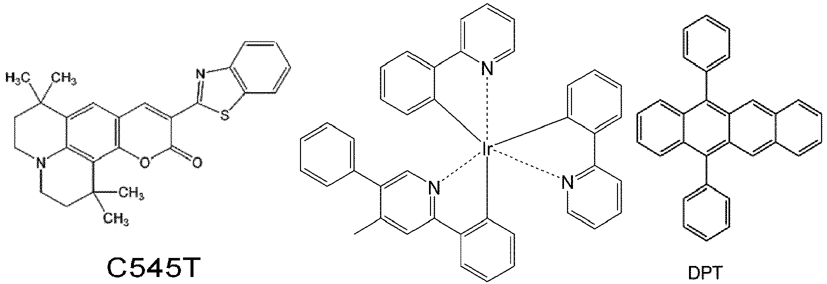

Non-limiting examples of the dopant that may be used in the organic EMLs 130 include Pt complexes represented by the following formulae.

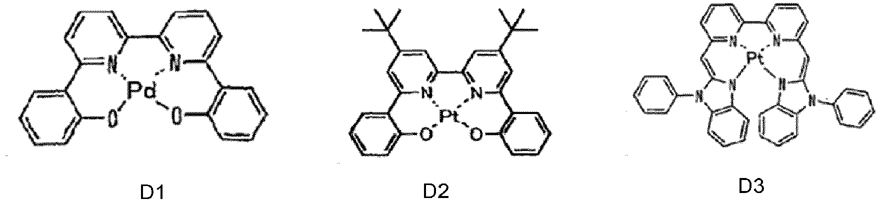

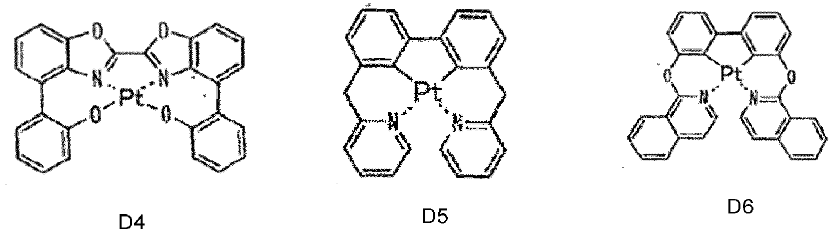

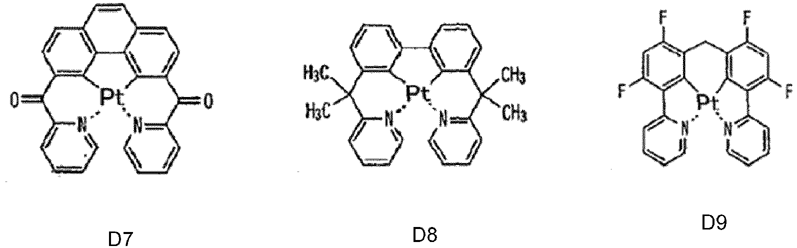

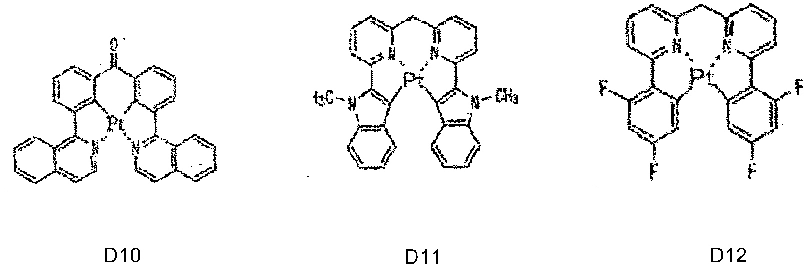

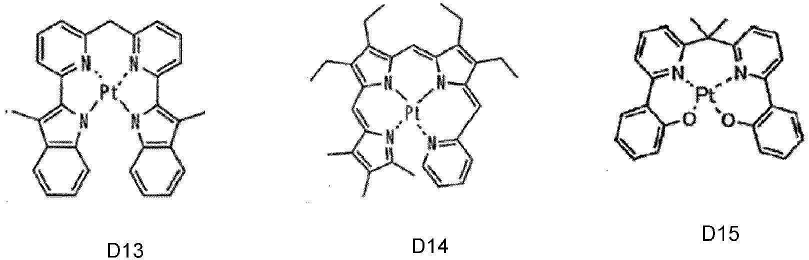

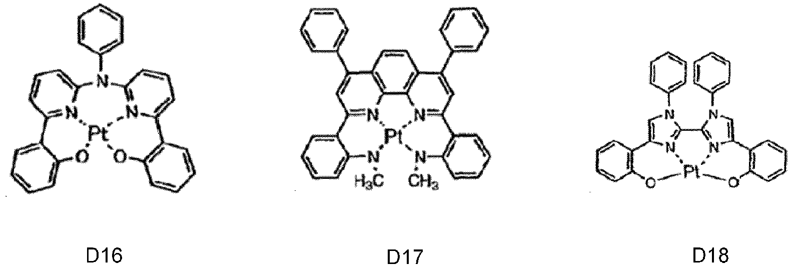

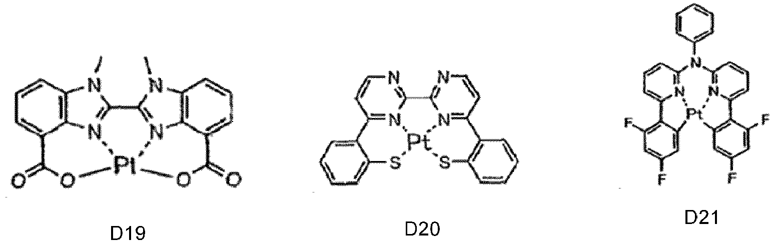

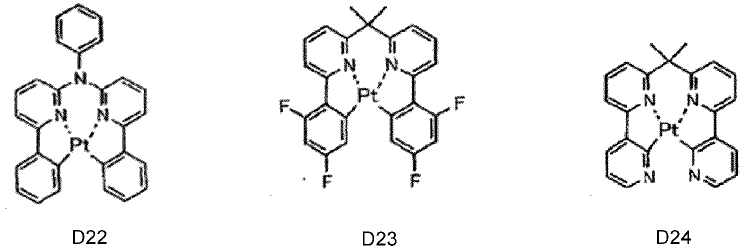

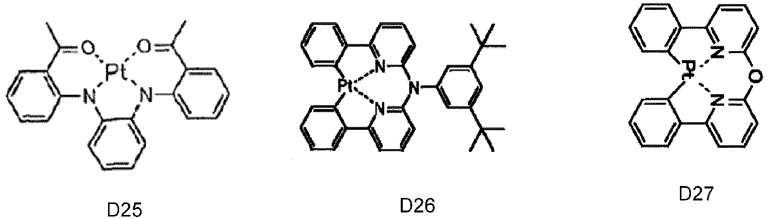

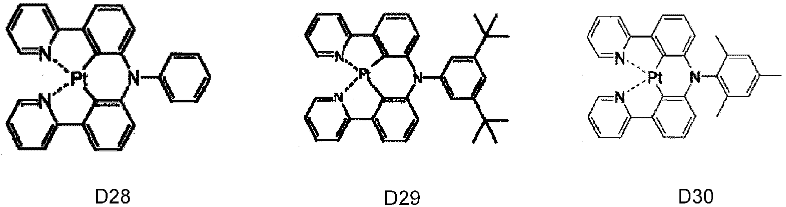

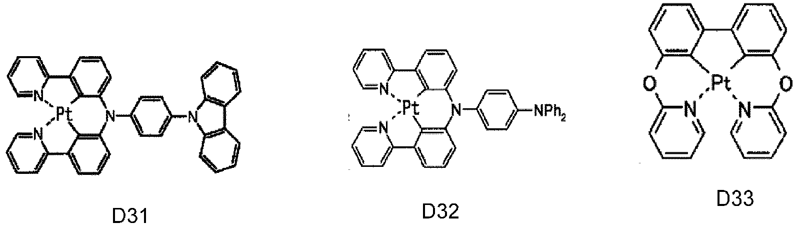

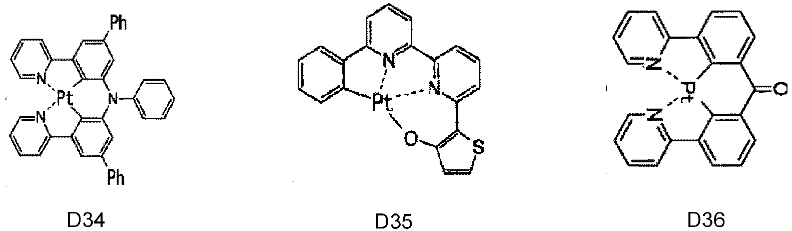

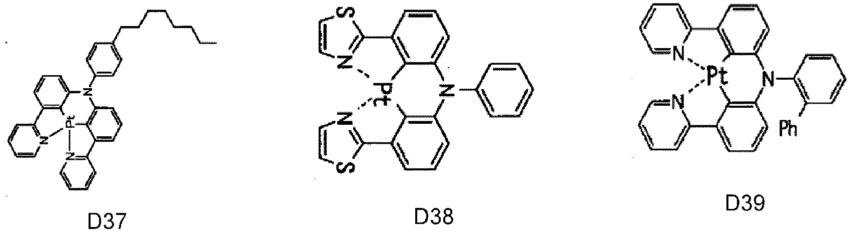

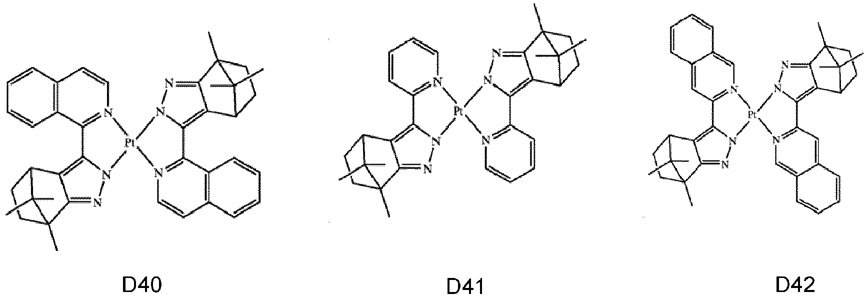

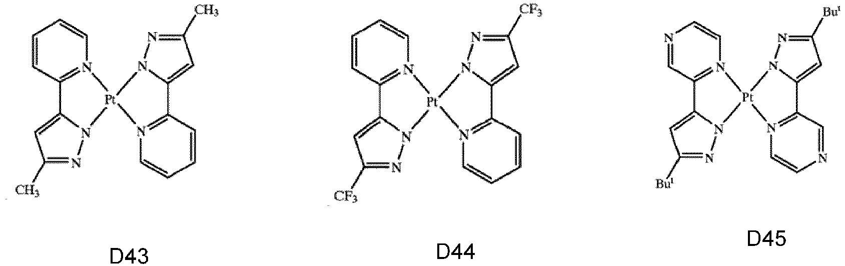

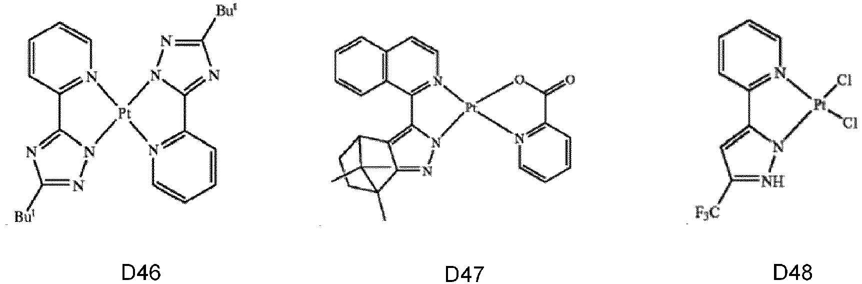

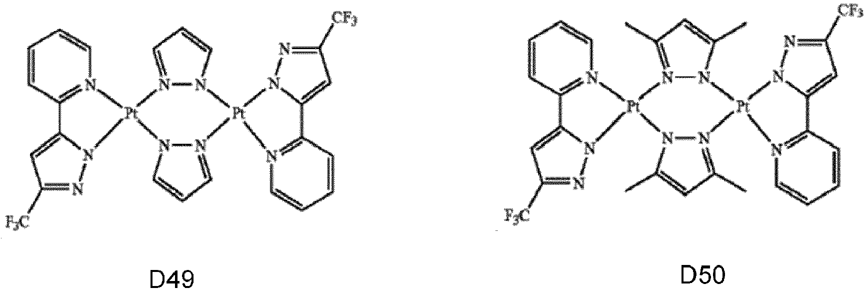

Non-limiting examples of the dopant that may be used in the organic EMLs 130 include Os complexes represented by the following formulae.

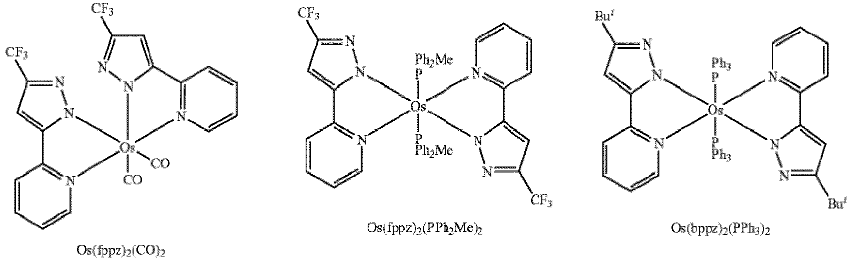

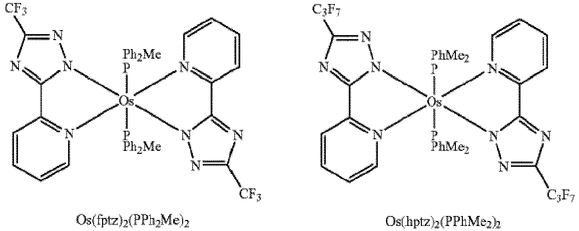

When the organic EMLs 130 include both a host material and a dopant material, the amount of the dopant material may be from about 0.01 parts to about 25 parts by weight based on 100 parts by weight of the host material. However, the amount of the dopant material is not limited to this range.

First, the third organic EML 130B may be formed as a common layer over the first sub-pixel SP1, the second sub-pixel SP2, and the third sub-pixel SP3. For example, when a blue EML is formed as the common layer, forming the blue EML over all three sub-pixels may be followed by forming red and green EMLs to be defined within the corresponding sub-pixels, respectively. The third organic EML 130B may have a thickness of from about 5 nm (50 Å) to about 50 nm (500 Å). When the thickness of the third organic EML 130B is within this range, satisfactory colour reproduction may be achieved without engendering a substantial increase in driving voltage. The first organic emission layer and the second organic emission layer may be substantially of the same thickness.

Next, the first doping auxiliary layer 125R may be formed on the third organic EML 130B within the first sub-pixel SP1. The first doping auxiliary layer 125R may be formed using a hole transport layer-forming material doped with a p-dopant, the amount of the p-type dopant being from about 5 to about 10wt% based on a total weight of the first doping auxiliary layer 125R. When the amount of the p-type dopant is within this range, an increase in driving voltage resulting from the inclusion of the resonance auxiliary layers may be suppressed. The first doping auxiliary layer 125R may have a thickness of from about 5 nm (50 Å) to about 20 nm (200 Å). When the thickness of the first doping auxiliary layer 125R is within this range, satisfactory colour reproduction may be achieved without a substantial increase in driving voltage.

Next, the first resonance auxiliary layer 126R may be formed on the first doping auxiliary layer 125R within the first sub-pixel SP1. The first resonance auxiliary layer 126R may be formed using a hole transport layer-forming material. The thickness of the first resonance auxiliary layer 126R may be appropriately selected from the range of from 10 nm (100 Å) to about 80 nm (800 Å) based on the resonance distance of the first sub-pixel SP1. The first resonance auxiliary layer may be of greater thickness than the second resonance auxiliary layer if the wavelength of light emitted from the first sub-pixel is longer than the wavelength of light emitted from the second sub-pixel, and the first resonance auxiliary layer may be of lesser thickness than the second resonance auxiliary layer if the wavelength of light emitted from the first sub-pixel is shorter than the wavelength of light emitted from the second sub-pixel.

Finally, the first organic EML 130R may be formed on the first resonance auxiliary layer 126B within the first sub-pixel SP1. The first organic EML 130R may have a thickness of from about 20 nm (200 Å) to about 80 nm (800 Å). When the thickness of the first organic EML 130R is within this range, satisfactory colour reproduction may be achieved without a substantial increase in driving voltage.

Likewise, the second doping auxiliary layer 125G, the second resonance auxiliary layer 126G, and the second organic EML 130G may be sequentially formed on the third organic EML 130B within the second sub-pixel SP2.

The electron transport layer 141 may be formed on the organic EMLs 130R, 130G and 130B. When the ETL 141 is formed using vacuum deposition or spin coating, the deposition and coating conditions may be similar to those for the formation of the HIL 121, though the deposition and coating conditions may vary according to the material that is used to form the ETL 141. Non-limiting examples of materials for forming the ETL 141, which stably transports electrons injected from the second electrode serving as an electron injecting electrode, are a quinoline derivative, such as tris(8-quinolinorate)aluminum (Alq3), TAZ, BAlq, beryllium bis(benzoquinolin-10-olate (Bebq2), and 9,10-di(naphthalene-2-yl)anthracene (ADN).

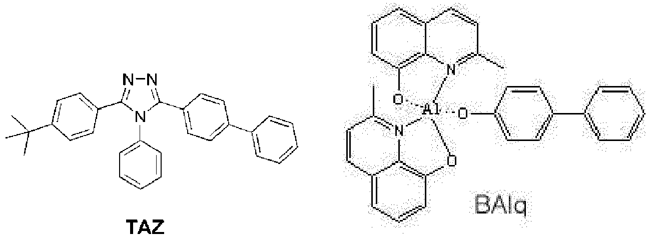

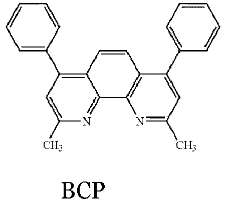

The thickness of the ETL 141 may be from about 5 nm (50Å) to about 100 nm (1,000 Å), and, in some embodiments, may be from about 10 nm (100Å) to about 50 nm (500Å). When the thickness of the ETL 141 is within these ranges, the ETL 141 may have satisfactory electron transporting ability without a substantial increase in driving voltage.

In some embodiments, the ETL 141 may further comprise a metal-containing compound in addition to the electron transporting material.

Non-limiting examples of the metal-containing compound are lithium quinolate (LiQ), Compound 101 below, and a mixture thereof.

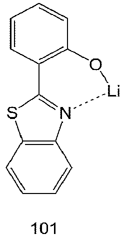

The ETL 142 may further comprise, in addition to the ETL-forming material, at least one of 1,4,5,8,9,12-hexaazatriphenylene hexacarbonitrile, tetracyanoquinodimethane, anthraquinone, perylenebisimide, and tetracyanoanthraquinodimethane. In some embodiments, the ETL 142 may further include, in addition to the ETL-forming material, at least one of a metal selected from lithium (Li), cesium (Cs), sodium (Na), potassium (K), calcium (Ca), magnesium (Mg), barium (Ba), and radium (Ra); metal carbonate; metal acetate; metal benzoate; metal acetoacetate; metal acetylacetonate; and metal stearate.

When the ETL 142 further comprises at least one of the above-listed materials in addition to the ETL-forming material, electron injection and transporting abilities may be improved.

The EIL 142, which may facilitate injection of electrons from the second electrode 150 may be disposed on the EIL 142. A material of the EIL 142 is not specifically limited. Materials suitable for the EIL 142 may be as described above but are not limited thereto.

Non-limiting examples of the EIL-forming material may be LiF, NaCl, CsF, Li₂O, and BaO, which are known in the art. The deposition and coating conditions for forming the EIL 142 may be similar to those for the formation of the HIL 121, though the deposition and coating conditions may vary according to the material that is used to form the EIL.

The thickness of the EIL 142 may be from about 0.1 nm (1 Å) to about 10 nm (100 Å), and, in some embodiments, may be from about 0.3 nm (3 Å) to about 9 nm (90 Å). When the thickness of the EIL 142 is within these ranges, the EIL 142 may have satisfactory electron injecting ability without a substantial increase in driving voltage.

The second electrode 150 may be disposed on the EIL 142. The second electrode 150 may be a cathode, which is an electron injecting electrode. A material for forming the second electrode 150 may be one of a metal, an alloy, an electrically conductive compound, and a mixture thereof, provided that the selected material has a low work function. In some embodiments, the second electrode 150 may be a transmission electrode and may be formed as a thin film of one of Li, Mg, Al, Al-Li, Ca, Mg-In, Mg-Ag, and the like.

In an embodiment, to manufacture a top-emission light-emitting device, the transmission electrode is formed of indium tin oxide (ITO) or indium zinc oxide (IZO). Referring to FIG. 2, the organic light-emitting device 200 according to another embodiment of the present invention includes the first charge generation layer 224R and the second charge generation layer 224G.

The first charge generation layer 224R may be formed using at least one selected from F4-TCNQ (2,3,5,6-tetrafluoro-7,7',8,8'-tetracyanoquinodimethane), TCNQ (7,7',8,8'-tetracyanoquinodimethane), HAT-CN (hexaazatriphenylene hexacarbonitrile), PTCDA (perylene-3,4,9,10-tetracarboxylic-3,4,9,10-dianhydride), 1,3,2-dioxaborin derivative, MoO₃, WO₃, ReO₃, V₂O₅, SnO₂, MnO₂, CoO₂, TiO₂, ZnO, NiO, Mo(tfd)₃, FeCl₃, FeF₃, SbCl₅, and fullerene (C₆₀), the first charge generation layer 224R being formed on the third organic EML 230B within the first sub-pixel SP1. The first charge generation layer 224R differs from the first doping auxiliary layer 225R in that the first charge generation layer 224R is formed of an undoped single material. The first charge generation layer 224R may have a thickness of from about 3 nm (30 Å) to about 10 nm (100 Å). When the thickness of the first charge generation layer 224R is within this range, satisfactory colour reproduction may be achieved without a substantial increase in driving voltage.

The second charge generation layer 224G may be formed on the third organic EML 230B within the second sub-pixel SP2. The material and thickness of the second charge generation layer 224G may be appropriately selected based on the material and thickness of the first charge generation layer 224R.

According to a second aspect of the present invention, an organic light-emitting display apparatus comprises: a transistor with a source, a drain, a gate, and an active layer; and the above-described organic light-emitting device, one of the source and the drain of the transistor being electrically connected to at least one of the first electrodes of the organic light-emitting device.

The active layer of the transistor may be in any of a variety of forms, for example, as an amorphous silicon layer, a crystalline silicon layer, an organic semiconductor layer, or an oxide semiconductor layer.

As used herein, the substituted methyl group means a substituted methyl group of which at least one hydrogen atom is substituted with one of a deuterium atom, a halogen atom, a hydroxyl group, a nitro group, a cyano group, an amino group, an amidino group, hydrazine, hydrazone, a carboxyl group or a salt thereof, a sulfonic acid group or a salt thereof, a phosphoric acid group or a salt thereof, a lower alkyl group, a lower alkenyl group, a lower alkynyl group, a C₆-C₃₀ aryl group, a C₂-C₃₀ heteroaryl group, -N(Q₁₀₁)(Q₁₀₂), and -Si(Q₁₀₃)(Q₁₀₄)(Q₁₀₅)(Q₁₀₆) (wherein Q₁₀₁ to Q₁₀₆ are each independently selected from the group consisting of a hydrogen atom, a lower alkyl group, a lower alkenyl group, a lower alkynyl group, a C₆-C₃₀ aryl group, and a C₂-C₃₀ heteroaryl group).

As used herein, the substituted ethyl group, the substituted propyl group, the substituted butyl group, the substituted ethenyl group, the substituted methoxy group, the substituted ethoxy group and the substituted propoxy group refers to those groups of which at least one hydrogen atom is substituted with a substituent as listed in conjunction with the substituted methyl group.

Hereinafter, the present invention will be described in detail with reference to the following illustrative examples.

### Example 1

To manufacture an anode, a corning 15 Ω/cm² (1200 Å) ITO glass substrate was cut to a size of 50 mm x 50 mm x 0.7 mm and then sonicated in isopropyl alcohol and pure water each for five minutes, and then cleaned by ultrasonication, followed by ultraviolet (UV) irradiation for about 30 minutes, and exposure to ozone for washing. The resulting glass substrate was loaded into a vacuum deposition device.

2-TNATA was deposited on the ITO glass substrate to form an HIL having a thickness of about 60 nm (600 Å) on the anode, and then 4,4'-bis[N-(1-naphthyl)-N-phenylamino]biphenyl (NPS) was vacuum-deposited on the HIL to form a HTL having a thickness of about 60 nm (600 Å).

DPVBi as a host and bis(2-(2-benzoxazolyl)phenolato)zinc(II) (Zn(BOX)2) were co-deposited on the HTL in a weight ratio of about 98:2 to form a common blue organic EML having a thickness of about 20 nm (200 Å).

Subsequently, NPB and Compound 201B were co-deposited on the blue organic EML in a red sub-pixel region in a weight ratio of about 97:3 to form a first doping auxiliary layer having a thickness of about 7 nm (70 Å), followed by depositing NPB on the first doping auxiliary layer to form a first resonance auxiliary layer having a thickness of about 60 nm (600 Å) and co-depositing Gaq3 as a host and DCJTB as a red dopant on the first resonance auxiliary layer in a weight ratio of about 98:2 thereby forming a red organic EML having a thickness of about 40 nm (400 Å).

Then, NPB and Compound 201B were co-deposited on the blue organic EML in a green sub-pixel region in a weight ratio of about 97:3 to form a second doping auxiliary layer having a thickness of about 7 nm (70 Å), followed by depositing NPB on the second doping auxiliary layer to form a second resonance auxiliary layer having a thickness of about 20 nm (200 Å) and co-depositing Alq3 as a host and DPT as a green dopant on the second resonance auxiliary layer in a weight ratio of about 98:2 thereby forming a green organic EML having a thickness of about 30 nm (300 Å).

Alq3 was deposited on the organic EML to form an ETL having a thickness of about 30 nm (300Å).

LiF was vacuum-deposited on the ETL to form an EIL having a thickness of about 1 nm (10 Å) and Al was vacuum-deposited on the EIL to form a cathode having a thickness of about 300 nm (3,000 Å), thereby completing the manufacture of an organic light-emitting device having the LiF/Al electrodes.

### Example 2

An organic light-emitting device was manufactured in the same manner as in Example 1, except that a first charge generation layer and a second charge generation layer were further formed as follows.

HAT-CN were deposited on the blue organic EML in a red sub-pixel region to form a first charge generation layer having a thickness of about 5 nm (50 Å), followed by co-depositing NPB and Compound 201B on the first charge generation layer in a weight ratio of about 97:3 to form a first doping auxiliary layer having a thickness of about 7 nm (70 Å), depositing NPB on the first doping auxiliary layer to form a first resonance auxiliary layer having a thickness of about 55 nm (550 Å), and co-depositing Gaq3 as a host and DCJTB as a red dopant on the first resonance auxiliary layer in a weight ratio of about 98:2 thereby forming a red organic EML having a thickness of about 40 nm (400 Å).

HAT-CN were deposited on the blue organic EML in a green sub-pixel region to form a second charge generation layer having a thickness of about 5 nm (50 Å), followed by co-depositing NPB and Compound 201B on the second charge generation layer in a weight ratio of about 97:3 to form a second doping auxiliary layer having a thickness of about 7 nm (70 Å), depositing NPB on the second doping auxiliary layer to form a second resonance auxiliary layer having a thickness of about 15 nm (150 Å), and co-depositing Alq3 as a host and DPT as a green dopant on the second resonance auxiliary layer in a weight ratio of about 98:2 thereby forming a green organic EML having a thickness of about 30 nm (300 Å).

### Example 3

An organic light-emitting device was manufactured in the same manner as in Example 1, except that a first resonance auxiliary layer and a first lower resonance auxiliary layer, instead of the first resonance auxiliary layer, and a second resonance auxiliary layer and a second lower resonance auxiliary layer, instead of the second resonance auxiliary layer, were formed as follows.

NPB was deposited on the blue organic EML in a red sub-pixel region to form a first lower resonance auxiliary layer having a thickness of about 5 nm (50 Å), followed by co-depositing NPB and Compound 201B in a weight ratio of about 97:3 on the first lower resonance auxiliary layer to form a first doping auxiliary layer having a thickness of about 7 nm (70 Å), depositing NPB on the first doping auxiliary layer to form a first resonance auxiliary layer having a thickness of about 55 nm (550 Å), and co-depositing Gaq3 as a host and DCJTB as a red dopant in a weight ratio of about 98:2 on the first resonance auxiliary layer, thereby forming a red organic EML having a thickness of about 40 nm (400Å).

NPB was deposited on the blue organic EML in a green sub-pixel region to form a first lower resonance auxiliary layer having a thickness of about 5 nm (50 Å), followed by co-depositing NPB and Compound 201B in a weight ratio of about 97:3 on the first lower resonance auxiliary layer to form a second doping auxiliary layer having a thickness of about 7 nm (70 Å), depositing NPB on the second doping auxiliary layer to form a second resonance auxiliary layer having a thickness of about 15 nm (150 Å), and co-depositing Alq3 as a host and DPT as a green dopant in a weight ratio of about 98:2 on the second resonance auxiliary layer, thereby forming a green organic EML having a thickness of about 30 nm (300 Å).

### Example 4

An organic light-emitting device was manufactured in the same manner as in Example 1, except that additional first and second charge generation layers, a first resonance auxiliary layer and a first lower resonance auxiliary layer, instead of the first resonance auxiliary layer, and a second resonance auxiliary layer and a second lower resonance auxiliary layer, instead of the second resonance auxiliary layer, were formed as follows.

HAT-CN was deposited on the blue organic EML in a red sub-pixel region to form a first charge generation layer having a thickness of about 7 nm (70 Å), followed by depositing NPB on the first charge generation layer to form a first lower resonance auxiliary layer having a thickness of about 5 nm(50 Å), co-depositing NPB and Compound 201B in a weight ratio of about 97:3 on the first lower resonance auxiliary layer to form a first doping auxiliary layer having a thickness of about 7 nm (70 Å), depositing NPB on the first doping auxiliary layer to form a first resonance auxiliary layer having a thickness of about 48 nm (480 Å), and co-depositing Gaq3 as a host and DCJTB as a red dopant in a weight ratio of about 98:2 on the first resonance auxiliary layer, thereby forming a red organic EML having a thickness of about 400 Å.

HAT-CN was deposited on the blue organic EML in a green sub-pixel region to form a second charge generation layer having a thickness of about 7 nm (70 Å), followed by depositing NPB on the second charge generation layer to form a second lower resonance auxiliary layer having a thickness of about 5 nm (50 Å), co-depositing NPB and Compound 201B in a weight ratio of about 97:3 on the second lower resonance auxiliary layer to form a second doping auxiliary layer having a thickness of about 7 nm (70 Å), depositing NPB on the second doping auxiliary layer to form a second resonance auxiliary layer having a thickness of about 18 nm (180 Å), and co-depositing Alq3 as a host and DPT as a green dopant in a weight ratio of about 98:2 on the second resonance auxiliary layer, thereby forming a green organic EML having a thickness of about 30 nm (300Å).

### Comparative Example 1

An organic light-emitting device was manufactured in the same manner as in Example 1, except that the first doping auxiliary layer and the second doping auxiliary layer of Example 1 were not formed.

### Evaluation Example

Driving voltages, luminescent efficiencies, and colour coordinates in the green sub-pixels of the organic light-emitting devices manufactured according to Examples 1 to 4 and Comparative Example 1 were measured using a PR650 (Spectroscan) source measurement unit (available from Photo Research, Inc.). The results are shown in Table 1 below.

**Table 1**

| Example | Driving voltage (V) | Current density (mA/cm²) | Luminescent efficiency (cd/A) | CIE_x | CIE-y |
|---|---|---|---|---|---|
| Example 1 | 5.4 | 12.5 | 74 | 0.214 | 0.741 |
| Example 2 | 5.1 | 11.5 | 71 | 0.216 | 0.740 |
| Example 3 | 7.2 | 10.9 | 75 | 0.221 | 0.739 |
| Example 4 | 5.3 | 13.8 | 72 | 0.220 | 0.739 |
| Comparative Example 1 | 9.5 | 15.2 | 58 | 0.217 | 0.740 |

Referring to Table 1, the organic light-emitting devices of Examples 1-4 were found to have lower driving voltages and improved luminance, when compared with the organic light-emitting device of Comparative Example 1. The driving voltages of the organic light-emitting devices of Examples 1, 2 and 4 were far lower relative to the driving voltage of the organic light-emitting device of Comparative Example 1. The driving voltage of the organic light-emitting device of Example 2 was about 4V lower than that of the organic light-emitting device of Comparative Example 1.

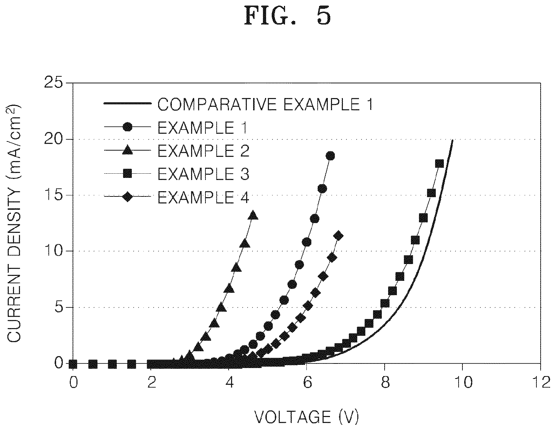

FIG. 5 is a graph of current density with respect to driving voltage in organic light-emitting devices manufactured according to Examples 1-4 and Comparative Example 1. Referring to FIG. 5, the organic light-emitting devices of Examples 1, 2, and 4 had lower driving voltages as compared with the organic light-emitting device of Comparative Example 1, and the organic light-emitting device of Example 3 had a similar driving voltage to that of the organic light-emitting device of Comparative Example 1.

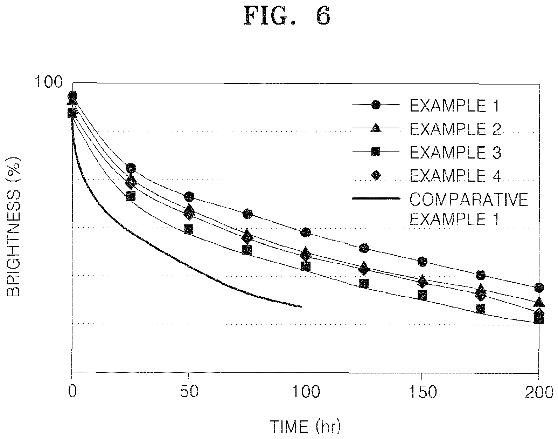

FIG. 6 is a graph showing lifetime characteristics of the organic light-emitting devices manufactured according to Examples 1-4 and Comparative Example 1 at a luminance of about 400 nit. Referring to FIG. 6, the organic light-emitting devices of Examples 1-4 were found to have improved lifetime characteristics, as compared with the organic light-emitting device of Comparative Example 1.

In particular, the organic light-emitting devices of Examples 1-4 were found to have a considerable reduction in luminance while operating for about 100 hours, as compared with the organic light-emitting device of Comparative Example 1.

These results indicate that an organic light-emitting device according to the invention in its first aspect may have improved driving voltage characteristics due to the suppression of driving voltage increase, and improved efficiency and lifetime, when compared with organic light-emitting devices with no doping auxiliary layer.

As described above, in an embodiment of the present invention, the organic light-emitting device includes a third organic EML as a common layer for the entire group of sub-pixels, wherein each sub-pixel includes a resonance auxiliary layer and a p-type doping auxiliary layer so that less misalignment occurs when forming the organic EML. Thus, the organic light-emitting device may show improvements in driving voltage characteristics, efficiency, and lifetime.

In an embodiment of the present invention, an increase in driving voltage of the organic light-emitting device may be suppressed so that the thickness of the resonance auxiliary layer is not specifically limited on the basis of any disadvantageous effect of the resonance auxiliary layer on the driving voltage. Furthermore, the resonance auxiliary and doping auxiliary layers may be formed through simplified processes without any need to form additional chambers in the subject sub-pixels.

In another aspect of the present invention, the organic light-emitting display apparatus may have improved driving voltage characteristics, improved efficiency, and improved lifetime.

## Claims

1. An organic light-emitting device, comprising: a substrate (101); a first sub-pixel (SP1),
a second sub-pixel (SP2), and a third sub-pixel (SP3); a first electrode (110) disposed in each of the first, second and third sub-pixels; a second electrode (150) disposed opposite to each of the first electrodes (110); a first organic emission layer (130R), a second organic emission layer (130G) and a third organic emission layer (130B), each disposed between the first electrode (110) and the second electrode (150),
the third organic emission layer (130B) being disposed as a common layer for the first sub-pixel (SP1),
the second sub-pixel (SP2) and the third sub-pixel (SP3), the first organic emission layer (130R) being disposed in the first sub-pixel (SP1) on the third organic emission layer (130B), the second organic emission layer (130G) being disposed in the second sub-pixel (SP2) on the third organic emission layer (130B); a first resonance auxiliary layer (126R) disposed between the third organic emission layer (130B) and the first organic emission layer (130R); a second resonance auxiliary layer (126G) disposed between the third organic emission layer (130B) and the second organic emission layer (130G); a first doping auxiliary layer (125R) disposed between the third organic emission layer (130B) and the first resonance auxiliary layer (126R); a second doping auxiliary layer (125G) disposed between the third organic emission layer (130B) and the second resonance auxiliary layer (126G); **characterized in that** the first doping auxiliary layer (125R) and the second doping auxiliary layer (125G) each independently comprise a hole transporting material and a p-type dopant; and wherein the first resonance auxiliary layer (126R) and the second resonance auxiliary layer (126G) have thicknesses corresponding to resonance distances of the first sub-pixel (SP1) and the second sub-pixel (SP2), respectively.

2. The organic light-emitting device of claim 1, wherein the p-type dopant comprises at least one of 2,3,5,6-tetrafluoro-7,7',8,8'-tetracyanoquinodimethane (F4-TCNQ), 7,7',8,8'-tetracyanoquinodimethane (TCNQ), hexaazatriphenylene hexacarbonitrile (HAT-CN), perylene-3,4,9,10-tetracarboxylic-3,4,9,10-dianhydride (PTCDA), 1,3,2-dioxaborin derivative, MoO₃, WO₃, ReO₃, V₂O₅, SnO₂, MnO₂, CoO₂, TiO₂, ZnO, NiO, Mo(tfd)₃, FeCl₃, FeF₃, SbCl₅, and fullerene (C₆₀); or
wherein the p-type dopant comprises at least one of the compounds represented by Formulae 1A to 12A, Formulae 1B to 5B and 9B, Formulae 2C, 3C and 5C, Formulae 3D and 5D and Formulae 5E, 5F, 5G, 5H, 51, 5J, 5K, 5L and 5M: 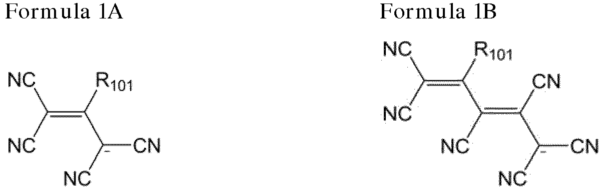 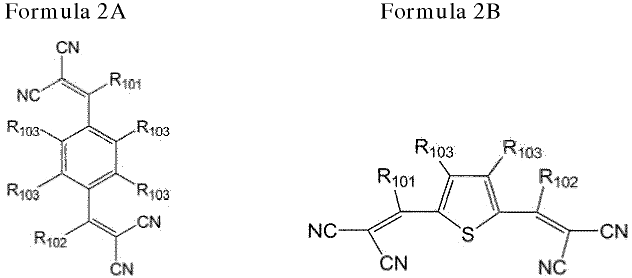 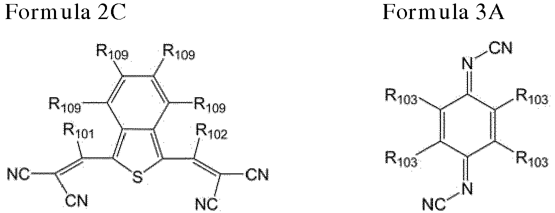 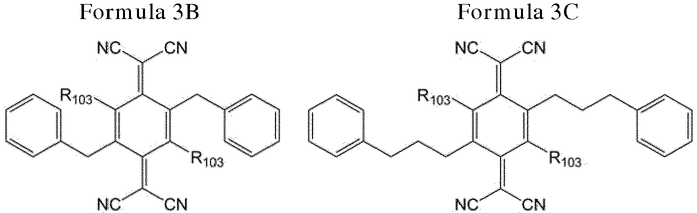 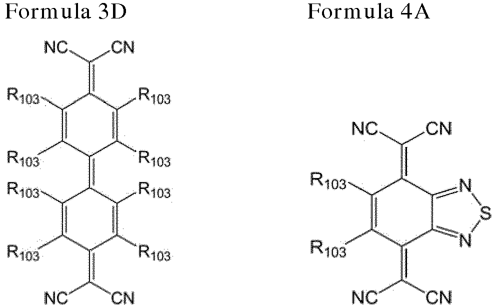 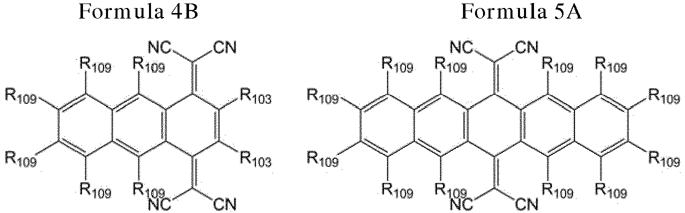 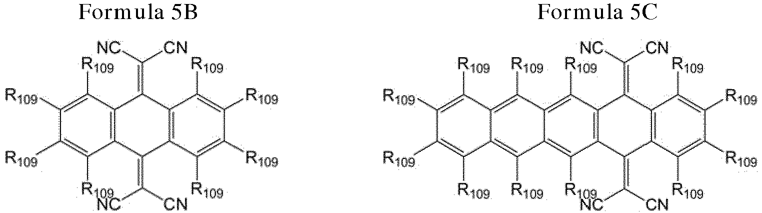 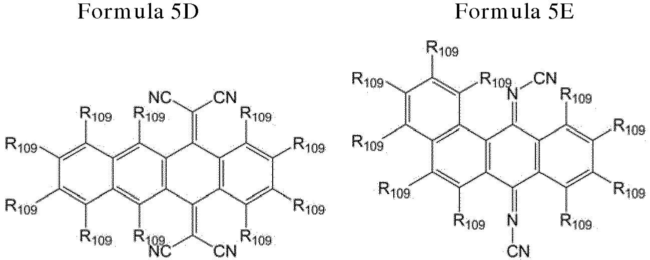 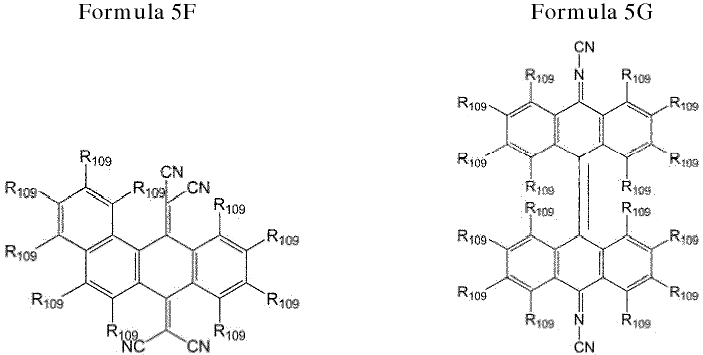 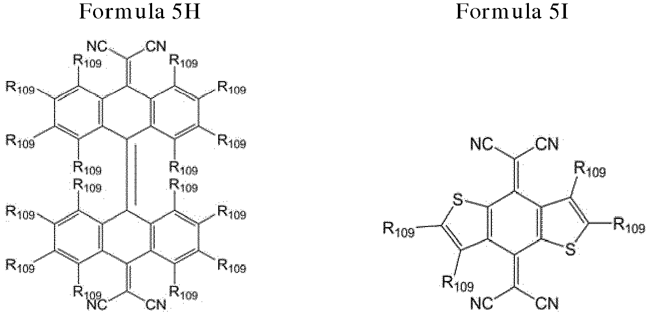 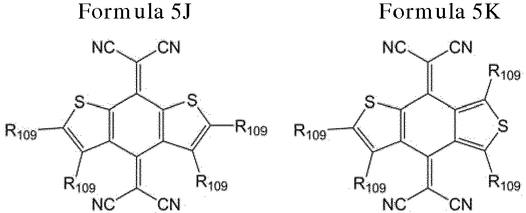 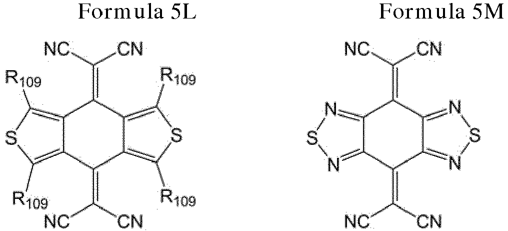 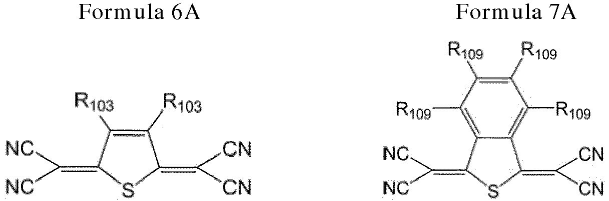 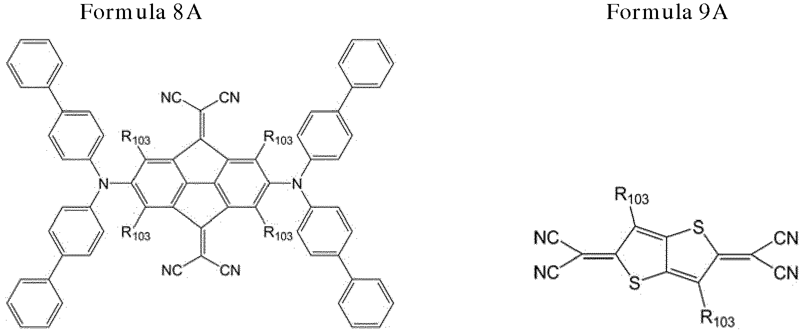 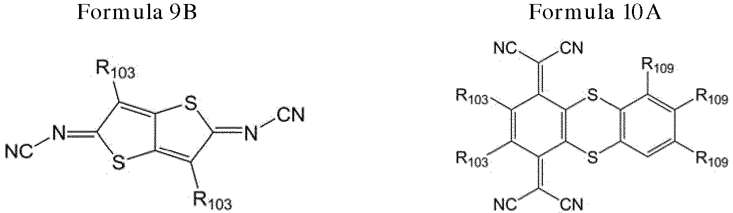 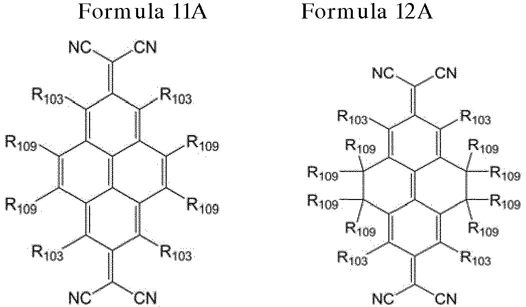 wherein R₁₀₁, R₁₀₂, R₁₀₃, and R₁₀₉ in Formulae 1A to 12A, Formulae 1B to 5B and 9B, Formulae 2C, 3C and 5C, Formulae 3D and 5D and Formulae 5E, 5F, 5G, 5H, 51, 5J, 5K, 5L and 5M are each independently selected from a hydrogen atom, a fluorine atom, a cyano group, a substituted or unsubstituted methyl group, a substituted or unsubstituted ethyl group, a substituted or unsubstituted propyl group, a substituted or unsubstituted butyl group, a substituted or unsubstituted ethenyl group, a substituted or unsubstituted methoxy group, a substituted or unsubstituted ethoxy group, and a substituted or unsubstituted propoxy group.

3. The organic light-emitting device of claim 1 or claim 2, wherein the concentration of the p-type dopant in one of the first doping auxiliary layer (125R) and the second doping auxiliary layer (125G) is from 5wt% to 10wt%, based on a total weight of the respective layer.

4. The organic light-emitting device of any preceding claim, wherein the first doping auxiliary layer (125R) is in contact with the first resonance auxiliary layer (126R), and the second doping auxiliary layer (125G) is in contact with the second resonance auxiliary layer (126G).

5. The organic light-emitting device of any preceding claim, wherein the third organic emission layer (130B) is a blue organic emission layer.

6. The organic light-emitting device of any preceding claim, further comprising a first charge generation layer (224R) disposed between the third organic emission layer and the first doping auxiliary layer and a second charge generation layer (224G) disposed between the third organic emission layer and the second doping auxiliary layer.

7. The organic light-emitting device of claim 6, wherein the first charge generation (224R) layer and the second charge generation layer (224G) each independently include at least one selected from 2,3,5,6-tetrafluoro-7,7',8,8'-tetracyanoquinodimethane (F4-TCNQ), 7,7',8,8'-tetracyanoquinodimethane (TCNQ), hexaazatriphenylene hexacarbonitrile (HAT-CN), perylene-3,4,9,10-tetracarboxylic-3,4,9,10-dianhydride (PTCDA), 1,3,2-dioxaborin derivative, MoO₃, WO₃, ReO₃, V₂O₅, SnO₂, MnO₂, CoO₂, TiO₂, ZnO, NiO, Mo(tfd)₃, FeCl₃, FeF₃, SbCl₅, and fullerene (C₆₀).

8. The organic light-emitting device of any preceding claim, further comprising at least one of a hole injection layer (121) and a hole transport layer (122), wherein the at least one of a hole injection layer (121) and a hole transport layer (122) is disposed between at least one first electrode (110) and the third organic emission layer (130B).

9. The organic light-emitting device of any preceding claim, further comprising at least one of an electron injection layer (142) and an electron transport layer (141), wherein the at least one of an electron injection layer (142) and an electron transport layer (141) is disposed between the second electrode (150) and the third organic emission layer (130B), preferably wherein the at least one of an electron injection layer (142) and an electron transport layer (141) comprises at least one of lithium quinolate (LiQ) and Compound 101, which is represented by the following formula:

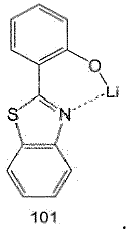

10. The organic light-emitting device of claim 9, further comprising a hole blocking layer disposed between the third organic emission layer (130B) and the electron transport layer (141).

11. The organic light-emitting device of any preceding claim, wherein the organic light-emitting device is a top-emission type device.

12. The organic light-emitting device of any preceding claim, further comprising:
a first lower resonance auxiliary layer (326R") disposed between the third organic emission layer and the first doping auxiliary layer; and a second lower resonance auxiliary layer (326G") disposed between the third organic emission layer and the second doping auxiliary layer.

13. The organic light-emitting device of claim 12, wherein the p-type dopant includes at least one of Compounds 201A and 201B, which are represented by the following formulae:

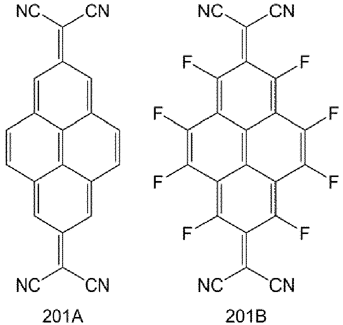

14. The organic light-emitting device of claim 12 or claim 13, wherein the first doping auxiliary layer is in contact with both the first resonance auxiliary layer and the first lower resonance auxiliary layer (326R"), and the second doping auxiliary layer being in contact with both the second resonance auxiliary layer and the second lower resonance auxiliary layer (326G").

15. The organic light-emitting device of any one of claims 12 to 14, wherein the first resonance auxiliary layer, the first lower resonance auxiliary layer (326R"), the second resonance auxiliary layer, and the second lower resonance auxiliary layer (326G") have thicknesses that correspond to resonance distances of the first sub-pixel and the second sub-pixel.

16. The organic light-emitting device of any one of claims 12 to 15, further comprising a first charge generation layer (424R) disposed between the third organic emission layer and the first lower resonance auxiliary layer (426R") and a second charge generation layer (424G) disposed between the third organic emission layer and the second lower resonance auxiliary layer (426G"), preferably wherein the first charge generation layer (424R) and the second charge generation layer (424G)
each independently comprise at least one selected from 2,3,5,6-tetrafluoro-7,7',8,8'-tetracyanoquinodimethane (F4-TCNQ), 7,7',8,8'-tetracyanoquinodimethane (TCNQ), hexaazatriphenylene hexacarbonitrile (HAT-CN), perylene-3,4,9,10-tetracarboxylic-3,4,9,10-dianhydride (PTCDA), 1,3,2-dioxaborin derivative, MoO₃, WO₃, ReO₃, V₂O₅, SnO₂, MnO₂, CoO₂, TiO₂, ZnO, NiO, Mo(tfd)₃, FeCl₃, FeF₃, SbCl₅, and fullerene (C₆₀).

17. An organic light-emitting display apparatus, comprising a transistor comprising a source;
a drain, a gate, and an active layer; and
the organic light-emitting device of any preceding claim,
one of the source and the drain being electrically connected to one of the first electrodes of the organic light-emitting device.

## Patentansprüche

1. Organische lichtemittierende Vorrichtung, umfassend: ein Substrat (101), ein erstes Subpixel (SP1), ein zweites Subpixel (SP2) und ein drittes Subpixel (SP3); eine erste Elektrode (110), angeordnet in jedem des ersten, zweiten und dritten Subpixels; eine zweite Elektrode (150), angeordnet gegenüber jeder der ersten Elektroden (110); eine erste organische Emissionsschicht (130R), eine zweite organische Emissionsschicht (130G) und eine dritte organische Emissionsschicht (130B), jeweils angeordnet zwischen der ersten Elektrode (110) und der zweiten Elektrode (150), wobei die dritte organische Emissionsschicht (130B) als gemeinsame Schicht für das erste Subpixel (SP1), das zweite Subpixel (SP2) und das dritte Subpixel (SP3) angeordnet ist, wobei die erste organische Emissionsschicht (130R) in dem ersten Subpixel (SP1) auf der dritten organischen Emissionsschicht (130B) angeordnet ist, wobei die zweite organische Emissionsschicht (130G) in dem zweiten Subpixel (SP2) auf der dritten organischen Emissionsschicht (130B) angeordnet ist; eine erste Resonanzhilfsschicht (126R), angeordnet zwischen der dritten organischen Emissionsschicht (130B) und der ersten organischen Emissionsschicht (130R); eine zweite Resonanzhilfsschicht (126G), angeordnet zwischen der dritten organischen Emissionsschicht (130B) und der zweiten organischen Emissionsschicht (130G); eine erste Dotierungshilfsschicht (125R), angeordnet zwischen der dritten organischen Emissionsschicht (130B) und der ersten Resonanzhilfsschicht (126R); eine zweite Dotierungshilfsschicht (125G), angeordnet zwischen der dritten organischen Emissionsschicht (130B) und der zweiten Resonanzhilfsschicht (126G); **dadurch gekennzeichnet, dass** die erste Dotierungshilfsschicht (125R) und die zweite Dotierungshilfsschicht (125G) jeweils unabhängig voneinander ein Lochtransportmaterial und einen Dotanten vom p-Typ umfassen; und wobei die erste Resonanzhilfsschicht (126R) und die zweite Resonanzhilfsschicht (126G) Dicken entsprechend den Resonanzabständen des ersten Subpixels (SP1) bzw. des zweiten Subpixels (SP2) aufweisen.

2. Organische lichtemittierende Vorrichtung nach Anspruch 1, wobei der Dotant vom p-Typ mindestens eines von 2,3,5,6-Tetrafluor-7,7',8,8'-tetracyanochinodimethan (F4-TCNQ), 7,7',8,8'-Tetracyanochinodimethan (TCNQ), Hexaazatriphenylenhexacarbonitril (HAT-CN), Perylen-3,4,9,10-tetracarbonsäure-3,4,9,10-dianhydrid (PTCDA), 1,3,2-Dioxaborin-Derivat, MoO₃, WO₃, ReO₃, V₂O₅, SnO₂, MnO₂, CoO₂, TiO₂, ZnO, NiO, Mo(tfd)₃, FeCl₃, FeF₃, SbCl₅ und Fulleren (C₆₀) umfasst; oder
wobei der Dotant vom p-Typ mindestens eine der Verbindungen, dargestellt durch die Formeln 1A bis 12A, die Formeln 1B bis 5B und 9B, die Formeln 2C, 3C und 5C, die Formeln 3D und 5D und die Formeln 5E, 5F, 5G, 5H, 5I, 5J, 5K, 5L und 5M, umfasst: 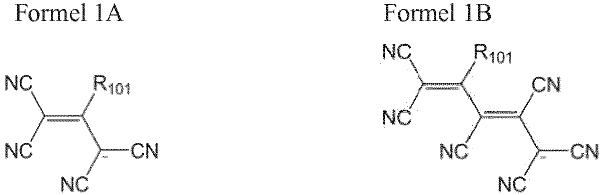 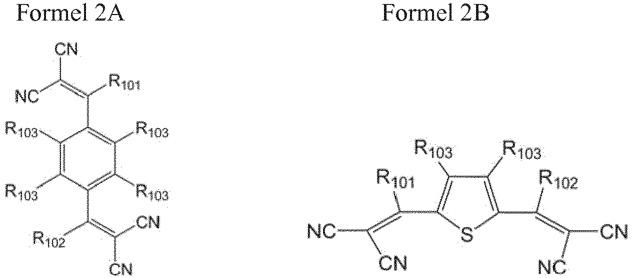 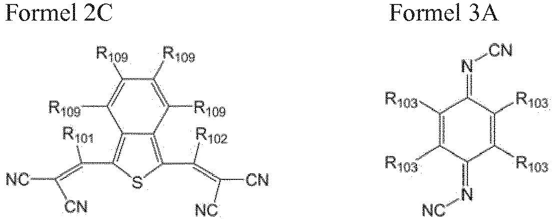 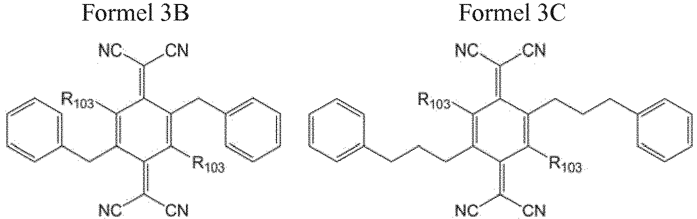 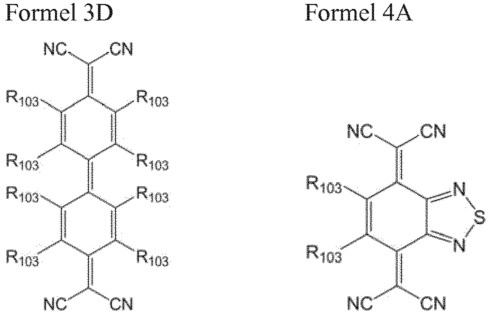 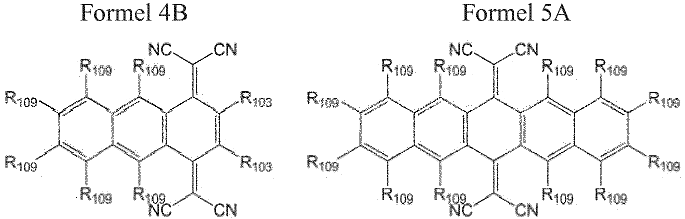 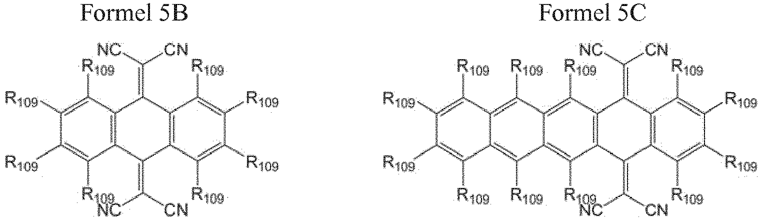 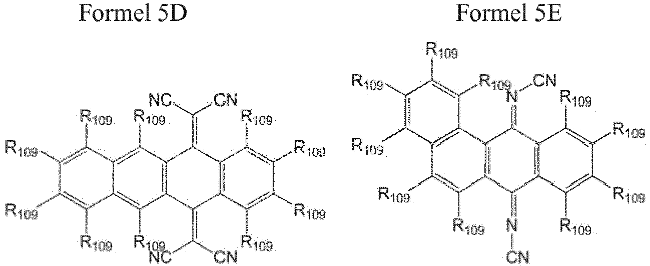 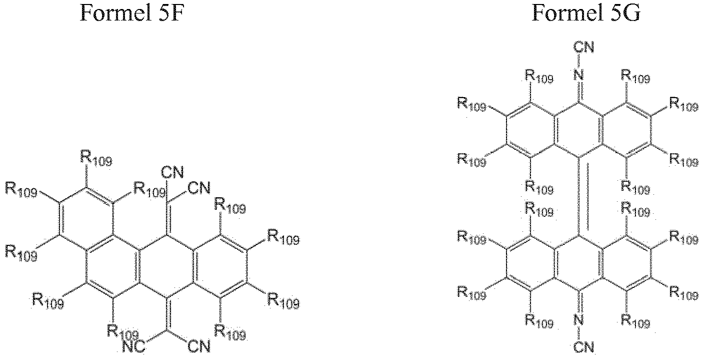 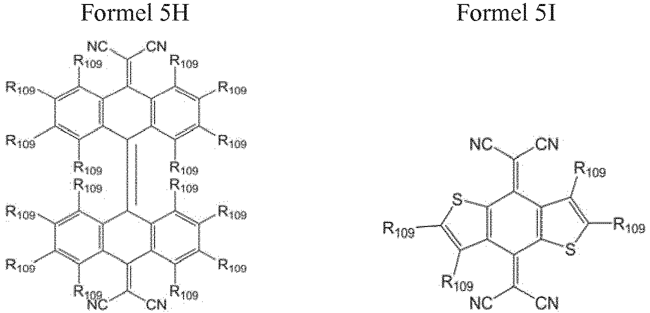 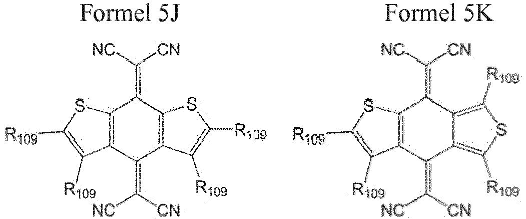 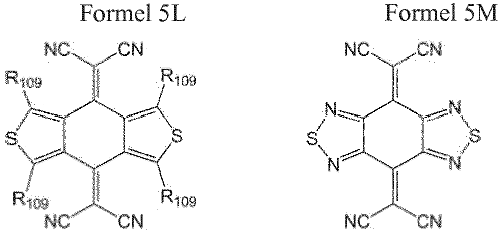 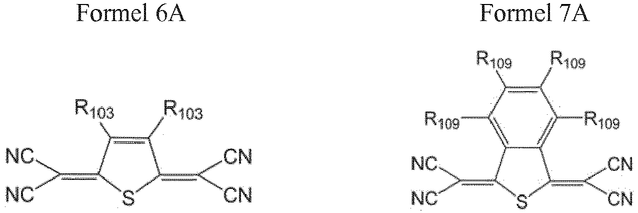 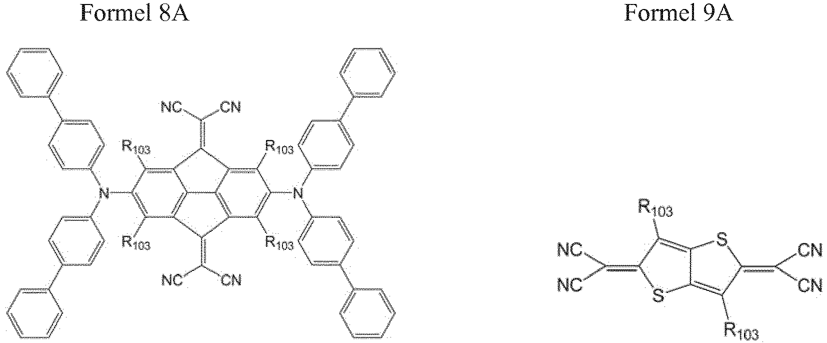 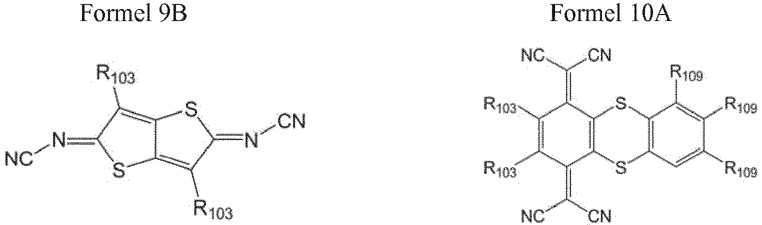 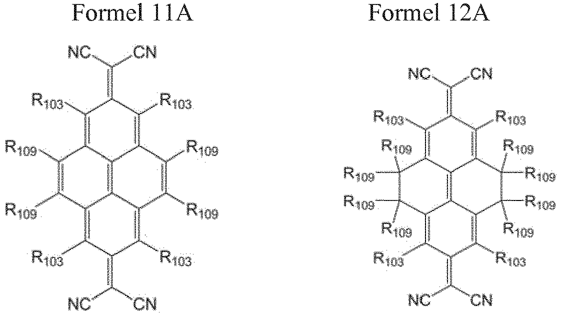 wobei R₁₀₁, R₁₀₂, R₁₀₃ und R₁₀₉ in den Formeln 1A bis 12A, den Formeln 1B bis 5B und 9B, den Formeln 2C, 3C und 5C, den Formeln 3D und 5D und den Formeln 5E, 5F, 5G, 5H, 51, 5J, 5K, 5L und 5M jeweils unabhängig voneinander ausgewählt sind aus einem Wasserstoffatom, einem Fluoratom, einer Cyanogruppe, einer substituierten oder unsubstituierten Methylgruppe, einer substituierten oder unsubstituierten Ethylgruppe, einer substituierten oder unsubstituierten Propylgruppe, einer substituierten oder unsubstituierten Butylgruppe, einer substituierten oder unsubstituierten Ethenylgruppe, einer substituierten oder unsubstituierten Methoxygruppe, einer substituierten oder unsubstituierten Ethoxygruppe und einer substituierten oder unsubstituierten Propoxygruppe.

3. Organische lichtemittierende Vorrichtung nach Anspruch 1 oder Anspruch 2, wobei die Konzentration des Dotanten vom p-Typ in einer von der ersten Dotierungshilfsschicht (125R) und der zweiten Dotierungshilfsschicht (125G) von 5 Gew.-% bis 10 Gew.-%, bezogen auf ein Gesamtgewicht der jeweiligen Schicht, beträgt.

4. Organische lichtemittierende Vorrichtung nach einem vorangehenden Anspruch, wobei die erste Dotierungshilfsschicht (125R) in Kontakt mit der ersten Resonanzhilfsschicht (126R) ist, und die zweite Dotierungshilfsschicht (125G) in Kontakt mit der zweiten Resonanzhilfsschicht (126G) ist.

5. Organische lichtemittierende Vorrichtung nach einem vorangehenden Anspruch, wobei die dritte organische Emissionsschicht (130B) eine blaue organische Emissionsschicht ist.

6. Organische lichtemittierende Vorrichtung nach einem vorangehenden Anspruch, weiterhin umfassend eine erste Ladungserzeugungsschicht (224R), angeordnet zwischen der dritten organischen Emissionsschicht und der ersten Dotierungshilfsschicht, und eine zweite Ladungserzeugungsschicht (224G), angeordnet zwischen der dritten organischen Emissionsschicht und der zweiten Dotierungshilfsschicht.

7. Organische lichtemittierende Vorrichtung nach Anspruch 6, wobei die erste Ladungserzeugungsschicht (224R) und die zweite Ladungserzeugungsschicht (224G) jeweils unabhängig voneinander mindestens eines, ausgewählt aus 2,3,5,6-Tetrafluor-7,7',8,8'-tetracyanochinodimethan (F4-TCNQ), 7,7',8,8'-Tetracyanochinodimethan (TCNQ), Hexaazatriphenylenhexacarbonitril (HAT-CN), Perylen-3,4,9,10-tetracarbonsäure-3,4,9,10-dianhydrid (PTCDA), 1,3,2-Dioxaborin-Derivat, MoO₃, WO₃, ReO₃, V₂O₅, SnO₂, MnO₂, CoO₂, TiO₂, ZnO, NiO, Mo(tfd)₃, FeCl₃, FeF₃, SbCl₅ und Fulleren (C₆₀), umfassen.

8. Organische lichtemittierende Vorrichtung nach einem vorangehenden Anspruch, weiterhin umfassend mindestens eine von einer Lochinjektionsschicht (121) und einer Lochtransportschicht (122), wobei die mindestens eine von einer Lochinjektionsschicht (121) und einer Lochtransportschicht (122) zwischen mindestens einer ersten Elektrode (110) und der dritten organischen Emissionsschicht (130B) angeordnet ist.

9. Organische lichtemittierende Vorrichtung nach einem vorangehenden Anspruch, weiterhin umfassend mindestens eine von einer Elektroneninjektionsschicht (142) und einer Elektronentransportschicht (141), wobei die mindestens eine von einer Elektroneninjektionsschicht (142) und einer Elektronentransportschicht (141) zwischen der zweiten Elektrode (150) und der dritten organischen Emissionsschicht (130B) angeordnet ist, vorzugsweise wobei die mindestens eine von einer Elektroneninjektionsschicht (142) und einer Elektronentransportschicht (141) mindestens eines von Lithiumchinolat (LiQ) und Verbindung 101, die durch die folgende Formel dargestellt wird, umfasst:

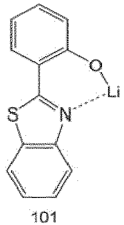

10. Organische lichtemittierende Vorrichtung nach Anspruch 9, weiterhin umfassend eine Lochsperrschicht, angeordnet zwischen der dritten organischen Emissionsschicht (130B) und der Elektronentransportschicht (141).

11. Organische lichtemittierende Vorrichtung nach einem vorangehenden Anspruch, wobei die organische lichtemittierende Vorrichtung eine Vorrichtung vom Top-Emission-Typ ist.

12. Organische lichtemittierende Vorrichtung nach einem vorangehenden Anspruch, weiterhin umfassend: eine erste untere Resonanzhilfsschicht (326R"), angeordnet zwischen der dritten organischen Emissionsschicht und der ersten Dotierungshilfsschicht; und eine zweite untere Resonanzhilfsschicht (326G"), angeordnet zwischen der dritten organischen Emissionsschicht und der zweiten Dotierungshilfsschicht.

13. Organische lichtemittierende Vorrichtung nach Anspruch 12, wobei der Dotant vom p-Typ mindestens eine der Verbindungen 201A und 201B, die durch die folgenden Formeln dargestellt werden, umfasst:

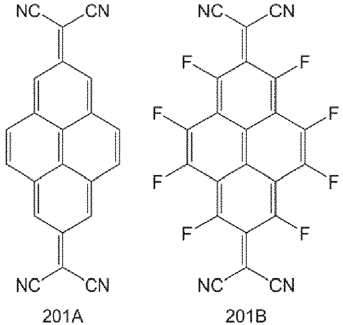

14. Organische lichtemittierende Vorrichtung nach Anspruch 12 oder Anspruch 13, wobei die erste Dotierungshilfsschicht in Kontakt mit sowohl der ersten Resonanzhilfsschicht als auch der ersten unteren Resonanzhilfsschicht (326R") ist, und wobei die zweite Dotierungshilfsschicht in Kontakt mit sowohl der zweiten Resonanzhilfsschicht als auch der zweiten unteren Resonanzhilfsschicht (326G") ist.

15. Organische lichtemittierende Vorrichtung nach einem der Ansprüche 12 bis 14, wobei die erste Resonanzhilfsschicht, die erste untere Resonanzhilfsschicht (326R"), die zweite Resonanzhilfsschicht und die zweite untere Resonanzhilfsschicht (326G") Dicken, die den Resonanzabständen des ersten Subpixels und des zweiten Subpixels entsprechen, aufweisen.

16. Organische lichtemittierende Vorrichtung nach einem der Ansprüche 12 bis 15, weiterhin umfassend eine erste Ladungserzeugungsschicht (424R), angeordnet zwischen der dritten organischen Emissionsschicht und der ersten unteren Resonanzhilfsschicht (426R"), und eine zweite Ladungserzeugungsschicht (424G), angeordnet zwischen der dritten organischen Emissionsschicht und der zweiten unteren Resonanzhilfsschicht (426G"), vorzugsweise wobei die erste Ladungserzeugungsschicht (424R) und die zweite Ladungserzeugungsschicht (424G) jeweils unabhängig voneinander mindestens eines, ausgewählt aus 2,3,5,6-Tetrafluor-7,7',8,8'-tetracyanochinodimethan (F4-TCNQ), 7,7',8,8'-Tetracyanochinodimethan (TCNQ), Hexaazatriphenylenhexacarbonitril (HAT-CN), Perylen-3,4,9,10-tetracarbonsäure-3,4,9,10-dianhydrid (PTCDA), 1,3,2-Dioxaborin-Derivat, MoO₃, WO₃, ReO₃, V₂O₅, SnO₂, MnO₂, CoO₂, TiO₂, ZnO, NiO, Mo(tfd)₃, FeCl₃, FeF₃, SbCl₅ und Fulleren (C₆₀), umfassen.

17. Organische lichtemittierende Anzeigevorrichtung, umfassend:
einen Transistor, umfassend eine Source;
einen Drain, ein Gate und eine aktive Schicht; und
die organische lichtemittierende Vorrichtung nach einem vorangehenden Anspruch,
wobei eines von der Source und dem Drain mit einer der ersten Elektroden der organischen lichtemittierenden Vorrichtung elektrisch verbunden ist.

## Revendications

1. Dispositif électroluminescent organique comprenant : un substrat (101) ; un premier sous-pixel (SP1), un deuxième sous-pixel (SP2) et un troisième sous-pixel (SP3) ; une première électrode (110) disposée dans chacun des premier, deuxième et troisième sous-pixels ; une deuxième électrode (150) disposée à l'opposé de chacune des premières électrodes (110) ; une première couche d'émission organique (130R), une deuxième couche d'émission organique (130G) et une troisième couche d'émission organique (130B), disposées chacune entre la première électrode (110) et la deuxième électrode (150), la troisième couche d'émission organique (130B) étant disposée sous la forme d'une couche commune pour le premier sous-pixel (SP1), le deuxième sous-pixel (SP2) et le troisième sous-pixel (SP3), la première couche d'émission organique (130R) étant disposée dans le premier sous-pixel (SP1) sur la troisième couche d'émission organique (130B), la deuxième couche d'émission organique (130G) étant disposée dans le deuxième sous-pixel (SP2) sur la troisième couche d'émission organique (130B) ; une première couche auxiliaire de résonance (126R) disposée entre la troisième couche d'émission organique (130B) et la première couche d'émission organique (130R) ; une deuxième couche auxiliaire de résonance (126G) disposée entre la troisième couche d'émission organique (130B) et la deuxième couche d'émission organique (130G) ; une première couche auxiliaire de dopage (125R) disposée entre la troisième couche d'émission organique (130B) et la première couche auxiliaire de résonance (126R) ; une deuxième couche auxiliaire de dopage (125G) disposée entre la troisième couche d'émission organique (130B) et la deuxième couche auxiliaire de résonance (126G) ; **caractérisé en ce que** chacune parmi la première couche auxiliaire de dopage (125R) et la deuxième couche auxiliaire de dopage (125G) comprend indépendamment un matériau de transport de trou et un dopant de type p ; et dans lequel la première couche auxiliaire de résonance (126R) et la deuxième couche auxiliaire de résonance (126G) ont des épaisseurs correspondant aux distances de résonance du premier sous-pixel (SP1) et du deuxième sous-pixel (SP2), respectivement.

2. Dispositif électroluminescent organique selon la revendication 1, dans lequel le dopant de type p comprend au moins l'un parmi le 2,3,5,6-tétrafluoro-7,7',8,8'-tétracyanoquinodiméthane (F4-TCNQ), le 7,7',8,8'-tétracyanoquinodiméthane (TCNQ), l'hexaazatriphénylène-hexacarbonitrile (HAT-CN), le dianhydride 3,4,9,10-pérylène-3,4,9,10-tétracarboxylique (PTCDA), un dérivé de 1,3,2-dioxaborine, MoO₃, WO₃, ReO₃, V₂O₅, SnO₂, MnO₂, CoO₂, TiO₂, ZnO, NiO, Mo(tfd)₃, FeCl₃, FeF₃, SbCl₅, et un fullerène (C₆₀) ; ou
dans lequel le dopant de type p comprend au moins l'un des composés représentés par les formules 1A à 12A, les formules 1B à 5B et 9B, les formules 2C, 3C et 5C, les formules 3D et 5D, et les formules 5E, 5F, 5G, 5H, 5I, 5J, 5K, 5L et 5M : 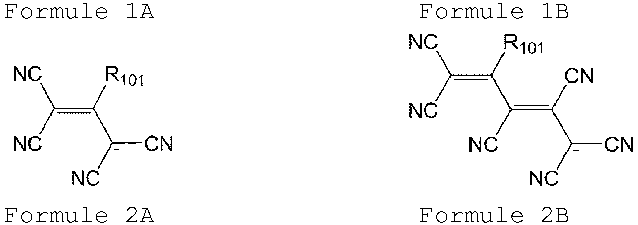 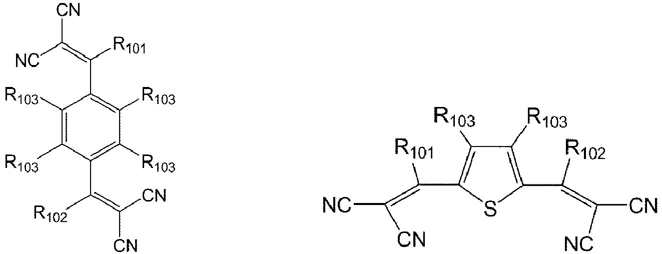 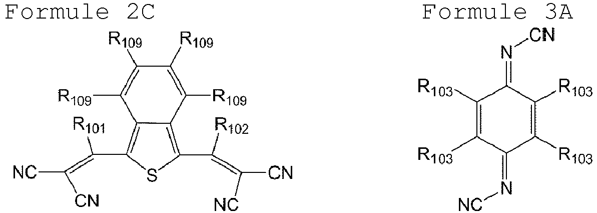 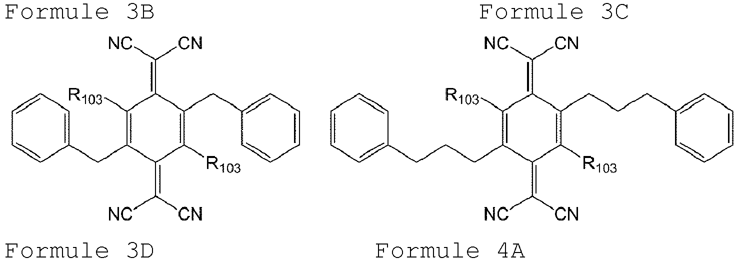 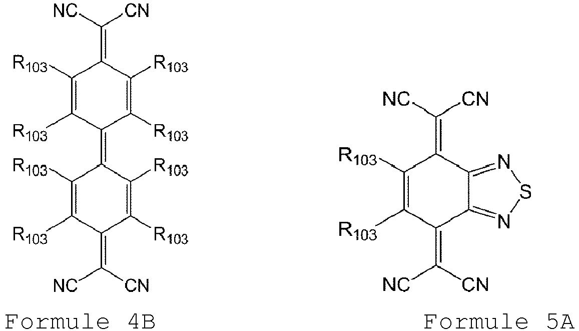 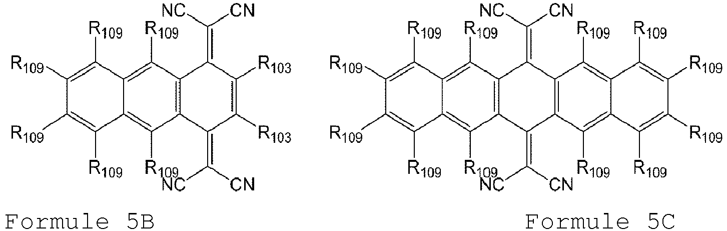 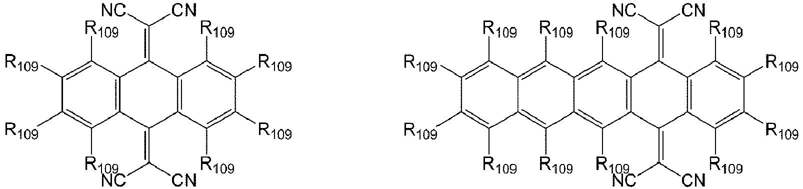 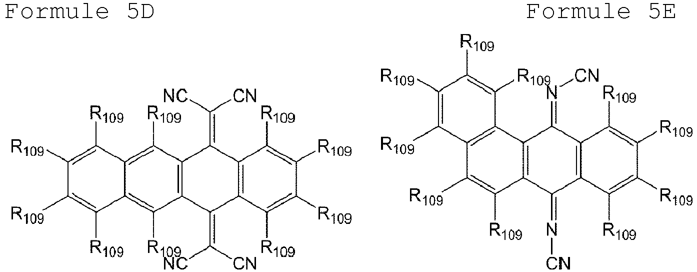 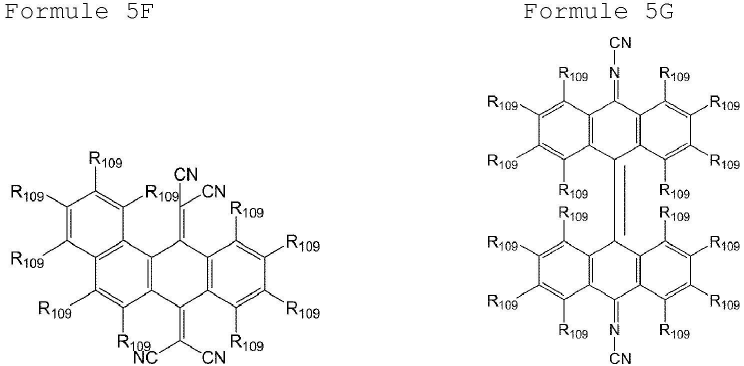 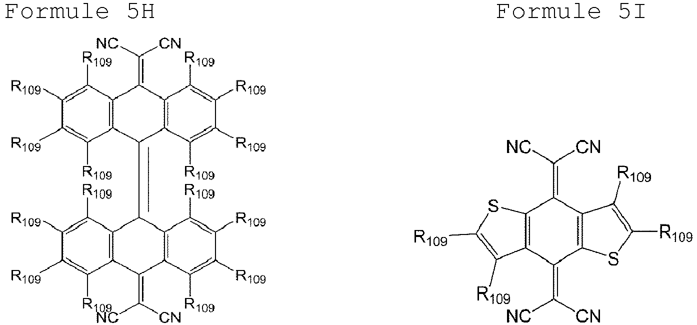 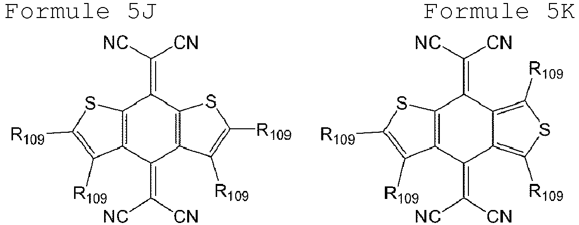 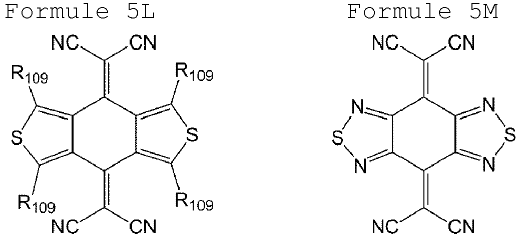 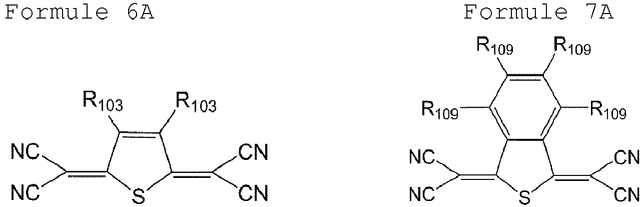 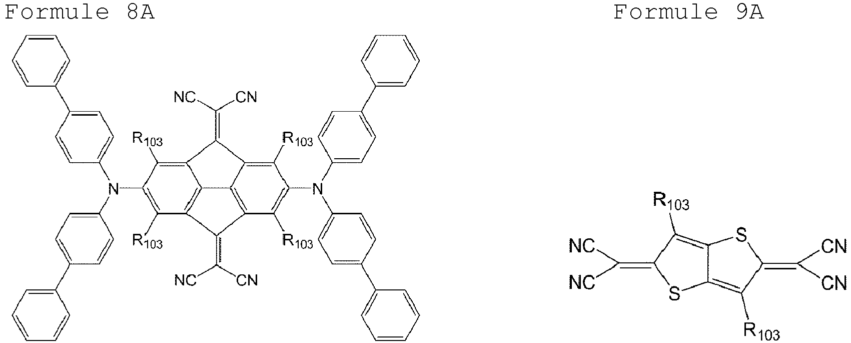 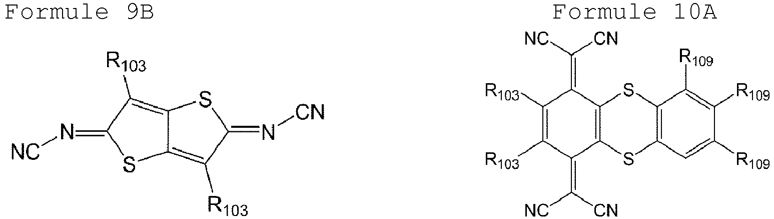 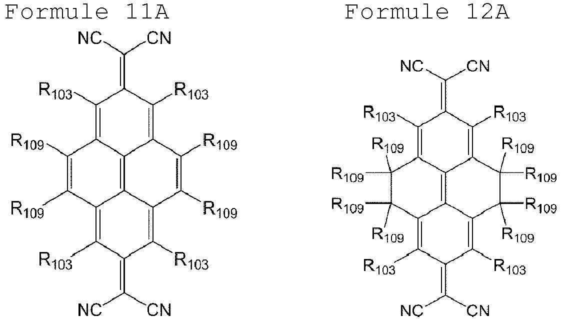 dans lesquelles chacun de R₁₀₁, R₁₀₂, R₁₀₃ et R₁₀₉ dans les formules 1A à 12A, les formules 1B à 5B et 9B, les formules 2C, 3C et 5D, les formules 3D et 5D, et les formules 5E, 5F, 5G, 5H, 5I, 5J, 5K, 5L et 5M est indépendamment choisi parmi un atome d'hydrogène, un atome de fluor, un groupe cyano, un groupe méthyle substitué ou non substitué, un groupe éthyle substitué ou non substitué, un groupe propyle substitué ou non substitué, un groupe butyle substitué ou non substitué, un groupe éthényle substitué ou non substitué, un groupe méthoxy substitué ou non substitué, un groupe éthoxy substitué ou non substitué, et un groupe propoxy substitué ou non substitué.

3. Dispositif électroluminescent organique selon la revendication 1 ou la revendication 2, dans lequel la concentration du dopant de type p dans l'une parmi la première couche auxiliaire de dopage (125R) et la deuxième couche auxiliaire de dopage (125G) est de 5 % en poids à 10 % en poids, par rapport au poids total de la couche respective.

4. Dispositif électroluminescent organique selon l'une quelconque des revendications précédentes, dans lequel la première couche auxiliaire de dopage (125R) est en contact avec la première couche auxiliaire de résonance (126R), et la deuxième couche auxiliaire de dopage (125G) est en contact avec la deuxième couche auxiliaire de résonance (126G).

5. Dispositif électroluminescent organique selon l'une quelconque des revendications précédentes, dans lequel la troisième couche d'émission organique (130B) est une couche d'émission organique bleue.

6. Dispositif électroluminescent organique selon l'une quelconque des revendications précédentes, comprenant en outre une première couche de génération de charge (224R) disposée entre la troisième couche d'émission organique et la première couche auxiliaire de dopage et une deuxième couche de génération de charge (224G) disposée entre la troisième couche d'émission organique et la deuxième couche auxiliaire de dopage.

7. Dispositif électroluminescent organique selon la revendication 6, dans lequel chacune parmi la première couche de génération de charge (224R) et la deuxième couche de génération de charge (224G) contient indépendamment au moins l'un choisi parmi le 2,3,5,6-tétrafluoro-7,7',8,8'-tétracyanoquinodiméthane (F4-TCNQ), le 7,7',8,8'-tétracyanoquinodiméthane (TCNQ), l'hexaazatriphénylène-hexacarbonitrile (HAT-CN), le dianhydride 3,4,9,10-pérylène-3,4,9,10-tétracarboxylique (PTCDA), un dérivé de 1,3,2-dioxaborine, MoO₃, WO₃, ReO₃, V₂O₅, SnO₂, MnO₂, CoO₂, TiO₂, ZnO, NiO, Mo(tfd)₃, FeCl₃, FeF₃, SbCl₅, et un fullerène (C₆₀).

8. Dispositif électroluminescent organique selon l'une quelconque des revendications précédentes, comprenant en outre au moins l'une parmi une couche d'injection de trou (121) et une couche de transport de trou (122), dans lequel l'au moins une parmi une couche d'injection de trou (121) et une couche de transport de trou (122) est disposée entre au moins une première électrode (110) et la troisième couche d'émission organique (130B).

9. Dispositif électroluminescent organique selon l'une quelconque des revendications précédentes, comprenant en outre au moins l'une parmi une couche d'injection d'électron (142) et une couche de transport d'électron (141), dans lequel l'au moins une parmi une couche d'injection d'électron (142) et une couche de transport d'électron (141) est disposée entre la deuxième électrode (150) et la troisième couche d'émission organique (130B), de préférence dans lequel l'au moins une parmi une couche d'injection d'électron (142) et une couche de transport d'électron (141) comprend au moins l'un parmi le quinolate de lithium (LiQ) et le composé 101 qui est représenté par la formule suivante :

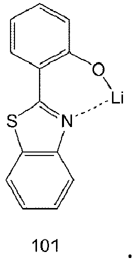

10. Dispositif électroluminescent organique selon la revendication 9, comprenant en outre une couche de blocage de trou disposée entre la troisième couche d'émission organique (130B) et la couche de transport d'électron (141) .

11. Dispositif électroluminescent organique selon l'une quelconque des revendications précédentes, le dispositif électroluminescent organique étant un dispositif du type à émission vers le haut.

12. Dispositif électroluminescent organique selon l'une quelconque des revendications précédentes, comprenant en outre : une première couche auxiliaire de résonance inférieure (326R") disposée entre la troisième couche d'émission organique et la première couche auxiliaire de dopage ; et une deuxième couche auxiliaire de résonance inférieure (326G") disposée entre la troisième couche d'émission organique et la deuxième couche auxiliaire de dopage.

13. Dispositif électroluminescent organique selon la revendication 12, dans lequel le dopant de type p contient au moins l'un des composés 201A et 201B, qui sont représentés par les formules suivantes :

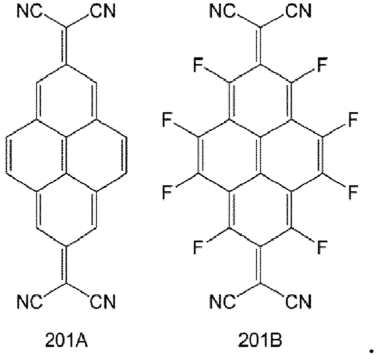

14. Dispositif électroluminescent organique selon la revendication 12 ou la revendication 13, dans lequel la première couche auxiliaire de dopage est en contact avec à la fois la première couche auxiliaire de résonance et la première couche auxiliaire de résonance inférieure (326R"), et la deuxième couche auxiliaire de dopage étant en contact avec à la fois la deuxième couche auxiliaire de résonance et la deuxième couche auxiliaire de résonance inférieure (326G").

15. Dispositif électroluminescent organique selon l'une quelconque des revendications 12 à 14, dans lequel la première couche auxiliaire de résonance, la première couche auxiliaire de résonance inférieure (326R"), la deuxième couche auxiliaire de résonance, et la deuxième couche auxiliaire de résonance inférieure (326G") ont des épaisseurs qui correspondent aux distances de résonance du premier sous-pixel et du deuxième sous-pixel.

16. Dispositif électroluminescent organique selon l'une quelconque des revendications 12 à 15, comprenant en outre une première couche de génération de charge (424R) disposée entre la troisième couche d'émission organique et la première couche auxiliaire de résonance inférieure (426R") et une deuxième couche de génération de charge (424G) disposée entre la troisième couche d'émission organique et la deuxième couche auxiliaire de résonance inférieure (426G"), de préférence dans lequel chacune parmi la première couche de génération de charge (424R) et la deuxième couche de génération de charge (424G) comprend indépendamment au moins l'un choisi parmi le 2,3,5,6-tétrafluoro-7,7',8,8'-tétracyanoquinodiméthane (F4-TCNQ), le 7,7',8,8'-tétracyanoquinodiméthane (TCNQ), l'hexaaza-triphénylène-hexacarbonitrile (HAT-CN), le dianhydride 3,4,9,10-pérylène-3,4,9,10-tétracarboxylique (PTCDA), un dérivé de 1,3,2-dioxaborine, MoO₃, WO₃, ReO₃, V₂O₅, SnO₂, MnO₂, CoO₂, TiO₂, ZnO, NiO, Mo(tfd)₃, FeCl₃, FeF₃, SbCl₅, et un fullerène (C₆₀).

17. Dispositif d'affichage électroluminescent organique comprenant
un transistor comprenant une source ;
un drain, une grille, et une couche active ; et
le dispositif électroluminescent organique de l'une quelconque des revendications précédentes,
l'un parmi la source et le drain étant connecté électriquement à l'une des premières électrodes du dispositif électroluminescent organique.
